# FASCICULE DE BREVET EUROPEEN

(11) **EP 4 671 695 B1**
(45) Date de publication et mention de la délivrance du brevet: **02.12.2026**
(21) Numéro de dépôt: 25185064.0
(22) Date de dépôt: 25.06.2025
(51) Int. Cl.: G01D 5/26, G01C 19/72, G01L 1/24, G01N 21/77, G01P 15/093, G01P 15/097, G01V 8/20, G02B 6/293, G02B 6/12, G01H 9/00

(54) **SYSTEME DE MESURE DE TYPE MEMS OU NEMS MULTICAPTEURS AMELIORE**
VERBESSERTES MEMS- ODER NEMS-MESSSYSTEM MIT MEHREREN SENSOREN
IMPROVED MEMS OR NEMS MULTISENSOR MEASUREMENT SYSTEM

(30) Priorité: 28.06.2024 FR 2407058
(43) Date de publication de la demande: 31.12.2025
(73) Titulaire: Commissariat à l'Energie Atomique et aux Energies Alternatives, 75015 Paris (FR)
(72) Inventeur: TRZPIL, Wioletta, 38054 GRENOBLE CEDEX (FR)
(74) Mandataire: Atout PI Laplace

(56) Documents cités:
- EP-A1- 4 109 049
- US-A1- 2016 246 000

## Description

### DOMAINE DE L'INVENTION

La présente invention concerne le domaine des capteurs à base de MEMS ou NEMS, et plus particulièrement les capteurs utilisant un résonateur optique couplé avec au moins élément mécanique, et la mise en réseaux de ces capteurs.

### ETAT DE LA TECHNIQUE

Les capteurs à base de MEMS ou NEMS basés sur l'interaction d'une grandeur à mesurer avec un résonateur optique ont connu récemment un grand essor et sont de nature très variée. On entend par capteur MEMS ou NEMS tout capteur bénéficiant des techniques de microfabrication de la microélectronique.

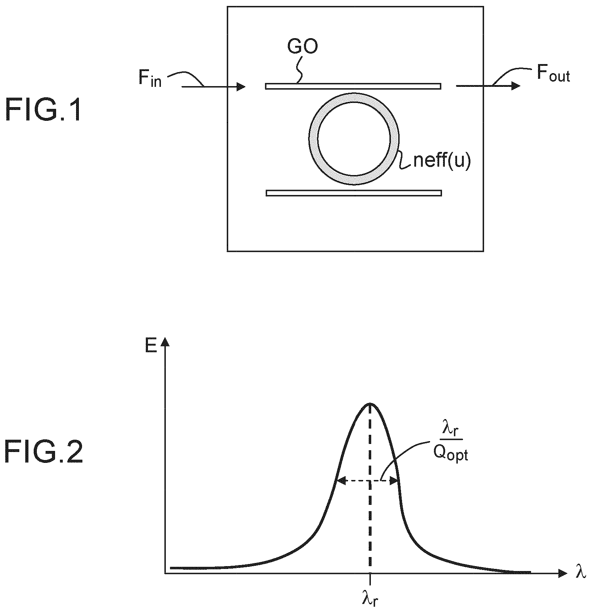

Un capteur de ce type comprend un résonateur optique RO, également dénommé cavité photonique, et un ou plusieurs guides d'ondes GO couplé(s) au résonateur optique, tel qu'illustré en figure 1. Le résonateur optique est caractérisé par au moins une longueur d'onde de résonance λr associée à une bande passante de résonance de largeur λr/Qopt (Qopt facteur de qualité de la cavité optique) tel qu'illustré en figure 2 qui décrit l'énergie E stockée dans le résonateur en fonction de la longueur d'onde.

Les propriétés de propagation des ondes EM dans le résonateur optique sont affectées par un mesurande *u* (grandeur physique à mesurer) ou un paramètre *u* dont la réponse dépend d'un mesurande d'intérêt *z.* Un faisceau lumineux de lecture Fin est injecté en entrée du capteur, et l'amplitude et/ou la phase du faisceau lumineux se propageant dans le ou les guide(s) d'onde couplé(s) au résonateur optique RO est perturbée par la grandeur *u.* La fonction de transmission ou de réflexion optique du capteur est ainsi modifiée, directement ou indirectement, par la grandeur physique à mesurer. Le faisceau Fout ressort par la sortie du capteur et est détecté par un photodétecteur, et on déduit du faisceau détecté une mesure de la grandeur u.

Dans l'exemple de la figure 1 le résonateur optique RO est un anneau dont l'indice effectif de propagation n_{eff}(*u*) dépend de *u* pour sa partie réelle et/ou imaginaire. La vitesse de propagation et/ou le taux de dissipation de l'onde lumineuse dans le résonateur optique dépendent ainsi de u.

Par exemple, pour un capteur destiné à identifier des objets biologiques, l'absorption d'un corps biologique ou autre à la surface du résonateur modifie son indice effectif de propagation et change la position de la longueur d'onde de résonance λr(*u*), *u* étant la quantité absorbée. A partir de la quantité absorbée on détermine la nature du corps (mesurande z).

Ainsi, l'identification du corps absorbé est réalisée par la couche de fonctionnalisation qui sélectionne les particules à détecter. Pour donner un exemple de mesurande z dans ce cas de capteur, on peut établir une relation entre le paramètre u qui correspond à une quantité de matériau à détecter et le mesurande z qui peut être la concentration de ce matériau. Les deux sont reliés par un processus d'absorption désorption et peuvent être décrits par une équation d'équilibre biochimique.

Selon un autre exemple, le capteur comprend un résonateur optique RO couplé avec un élément mécanique dont on mesure le déplacement. Ce type de capteur est dénommé capteur optomécanique.

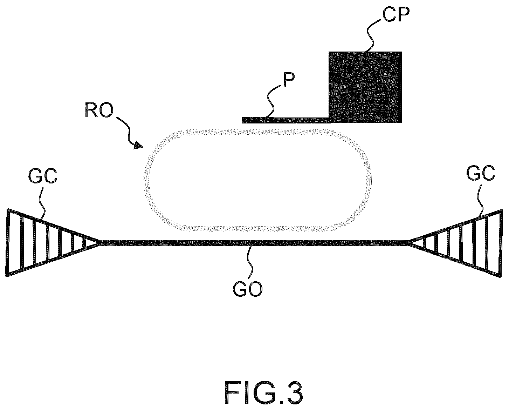

La figure 3 illustre un tel capteur dans lequel l'élément mécanique est une poutre cantilever P fixée à une extrémité à un plot CP. Le faisceau de lecture est injecté dans le guide GO et récupéré en sortie de guide par un réseau de couplage GC (« grating coupler »). Le déplacement x de la poutre (paramètre u) dans le champ évanescent du résonateur optique perturbe l'indice effectif (variation du «gap» entre la poutre et l'anneau). A partir du déplacement x on mesure par exemple l'accélération d'un corps (mesurande z).

Selon encore un autre exemple l'élément mécanique résonnant est confondu avec le résonateur optique, qui présente alors une résonance optique et une résonance mécanique.

Certains capteurs sont dits actifs, car ces capteurs utilisent l'énergie apportée par le mesurande pour réaliser la transduction, aucune excitation externe n'est appliquée au capteur: La force d'une l'onde ultrasonore active la membrane, la force inertielle met en mouvement une masse mobile, etc.

Pour une autre classe de capteurs, dit passifs, ces capteurs subissent une modification d'un de leurs paramètres physiques. Par exemple, la fréquence de résonance du système mécanique ou son facteur de qualité, la résistance électrique d'une jauge de déformation, etc. Dans ce cas, il est nécessaire d'apporter une excitation extérieure (une polarisation) pour réaliser la lecture de ce paramètre. Ce moyen d'excitation est nécessaire pour certaines catégories de capteur.

Par exemple l'élément mécanique résonnant est excité à une fréquence d'excitation externe fex comprise dans la bande de résonance mécanique BPm autour d'une fréquence de résonance mécanique frm.

Dans un autre exemple de capteur passif, le résonateur optique et le résonateur mécanique sont confondus. Il s'agit par exemple d'un disque vibrant présentant à la fois une résonance optique et mécanique : par exemple un capteur fonctionnant en milieu liquide pour détecter des objets biologiques (virus, protéines, etc) qui se déposent sur ce disque. On mesure la masse additionnelle absorbée sur ces disques (on utilise une couche de fonctionnalisation ou non), qui permet de remonter à la concentration de l'espèce biologique. La masse alourdit le disque, ce qui modifie sa fréquence de résonance mécanique. Il s'agit selon un autre exemple d'un capteur de force atomique sous la forme d'un anneau muni d'une pointe mise en résonance, tel que décrit dans la publication de Allain et al « Optomechanical resonating probe for very high frequency sensing of atomic forces » Nanoscale, 2020, 12, 2939.

Afin de multiplier les mesures et/ou d'augmenter la précision ou les fonctionnalités du capteur, il est intéressant de mettre ces capteurs actifs ou passifs en réseau. Se pose alors le problème de la lecture de l'information associée à chaque capteur.

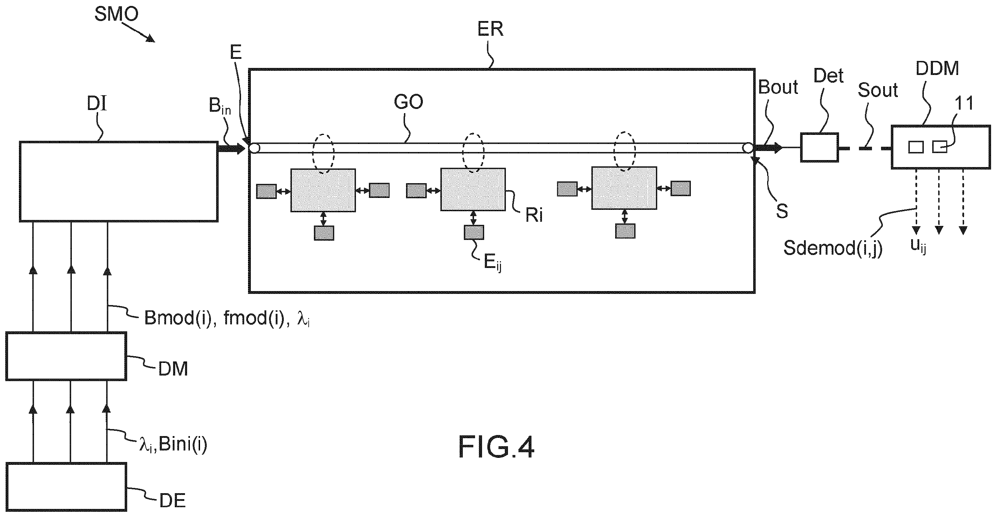

Le document EP4109049 décrit un système de mesure SM0 comprenant plusieurs résonateurs optiques couplés à un guide d'onde et des éléments associés aux résonateurs optiques illustré figure 4. Ce système de mesure permet la récupération simultanée de l'information individuelle issue de chaque capteur élémentaire résonateur optique/élément, et donc d'accéder à toutes les valeurs mesurées par tous les capteurs.

Le système SM0 comprend un ensemble résonnant ENR comprenant une entrée E et une sortie S, une pluralité de N résonateurs optiques Ri indicés i présentant chacun une longueur d'onde de résonance λr,i, et au moins un guide d'onde GO auquel sont couplés les résonateurs optiques.

Le système SM0 comprend également au moins un élément Eij couplé à chaque résonateur Ri et configuré pour modifier une transmission ou une réflexion optique au voisinage de la résonance du résonateur optique Ri associé, la modification étant fonction d'une grandeur physique à mesurer. Les résonateurs optiques sont indicés i variant de 1 à N, et les éléments associés à un résonateur i sont indicés j : Eij. Un ensemble Eij/Ri forme un capteur élémentaire Cij et l'ensemble ENR forme un réseau de capteurs. Au sein d'un ensemble ER plusieurs types de capteurs peuvent être mélangés. Des exemples de résonateurs Ri sont : un guide rebouclé sur lui-même (tel un anneau), un disque, un cristal photonique.

Comme expliqué plus haut la transmission/réflexion optique d'un résonateur Ri est modifiée par une grandeur physique u, qui peut être soit directement la grandeur physique finale que l'on souhaite mesurer, soit un paramètre duquel dépend la grandeur finale à mesurer z. Le système de mesure SM0 a pour objectif la mesure de la grandeur physique u. On dénomme uij la valeur mesurée de ce paramètre u par l'élément Eij associé au résonateur Ri (capteur Cij), et il est entendu que lorsque u est un paramètre intermédiaire, on détermine ensuite la mesure zij à partir de uij.

Le système de mesure SM0 comprend également un dispositif d'émission DE configuré pour émettre une pluralité de N faisceaux lumineux présentant chacun une longueur d'onde d'émission λi comprise dans la bande de résonance du résonateur optique associé Ri. On appelle bande spectrale de résonance du résonateur Ri la bande spectrale BPopt autour de la fréquence de résonance, caractérisée par le paramètre Qopt tel qu'illustré en figure 2 : BPopt = λr/Qopt. Les différentes longueurs d'onde λi doivent être choisies de manière à avoir des bandes spectrales de résonance disjointes, pour éviter qu'une longueur d'onde émise par un laser puisse adresser deux RO différents.

Le système comprend également un dispositif de modulation DM configuré pour moduler chacun des faisceaux lumineux à une fréquence de modulation fmod(i) et un dispositif d'injection DI configuré pour superposer les N faisceaux lumineux pour former un faisceau d'entrée *Bin* et pour injecter le faisceau en entrée de l'ensemble résonant ER. Le faisceau d'entrée *Bin* est le faisceau sonde, ou de lecture, qui va lire les mesures réalisées par les capteurs Cij, via la modification de la réponse optique des résonateurs Ri. Le faisceau en sortie de l'ensemble ENR est dénommé Bout.

La superposition des faisceaux s'effectue par exemple à l'aide de lames ou de cubes dénommés « beam splitters » en anglais, ou avec un multiplexeur dénommé Arrayed Waveguide Grating (AWG). L'injection dans le guide d'onde s'opère par exemple avec une fibre optique couplée à un réseau de diffraction (« grating coupler » en anglais) ou par un couplage par la tranche, avec une fibre optique positionnée dans le même plan que le substrat.

Le système comprend également au moins un détecteur Det, par exemple une photodiode, configuré pour détecter un faisceau lumineux issu du faisceau en sortie *Bout,* et générer un signal électrique de sortie *Sout.*

Sur la figure 4 et les suivantes, les faisceaux optiques sont symbolisés par un trait plein et les signaux électriques par un trait en pointillé, pour rendre les schémas plus lisibles.

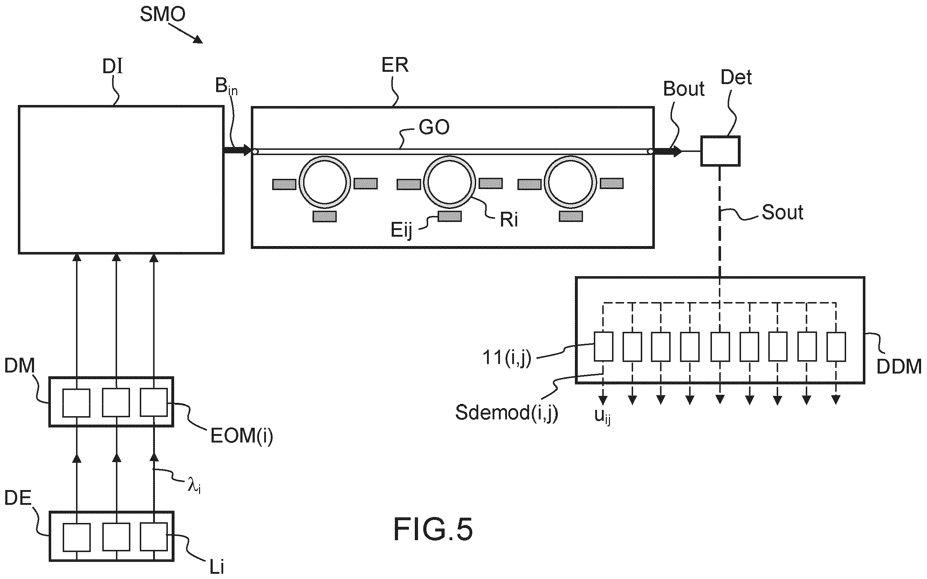

Selon un exemple le dispositif d'émission DE comprend par exemple N lasers Li émettant des faisceaux Bini(i) et le dispositif de modulation DM comprend N modulateurs disposés respectivement sur les trajets optiques des N faisceaux lumineux émis par les N lasers, et configurés pour moduler chaque faisceau lumineux à la fréquence fmod(i). Les modulateurs sont par exemple des modulateurs électrooptiques EOM(i) (voir figure 5).

Le dispositif de modulation DM réalise une modulation d'intensité. Cette modulation d'intensité s'effectue par exemple de manière directe (lasers modulés), via une absorption (modulateurs électro optiques), via une interférence de type Mach Zender (MZ) ou une interférence de type résonateur.

Le système SM0 comprend enfin un dispositif de démodulation DDM comprenant une pluralité de modules de démodulation 11 de type détection synchrone pour démoduler le signal de sortie, de manière à extraire des signaux caractéristiques Sdemod(i,j) associés à chaque élément Eij, les valeurs mesurées uij de la grandeur physique u étant déterminées à partir des signaux caractéristiques.

Le principe du système SM0 est que l'information relative à une longueur d'onde λi est codée par une modulation de fréquence à fmod(i), permettant la récupération de cette information non pas par un démultiplexage en longueur d'onde mais par un traitement électronique de démodulation de type détection synchrone. Les signaux aux fréquences d'intérêt sont extraits électroniquement avec un très bon rapport signal sur bruit. L'extraction s'effectue par des blocs analogiques ou numériques.

Dans ce document il est démontré que l'information d'intérêt uij est codée sur les composantes de l'intensité optique de sortie Iₒᵤₜ de pulsation Δi+/-Ωij , avec :

Δi = 2.π.fmod(i) ; Ωᵢⱼ = 2.π.fc(i,j) ; fc(i,j) fréquence d'excitation appliquée à l'élément résonant Eij.

Grâce à la linéarisation des fonctions de transmission, les signaux d'intérêt sont accessibles par un codage/décodage de type modulation/démodulation. L'utilisation d'une détection synchrone permet d'extraire directement le signal de phase avec un très bon SNR. Les signaux démodulés Sdemod(i,j) permettent d'isoler les mesurandes associés à chaque capteur photonique Cij individuel car les signaux sont positionnés sur des bandes spectrales différentes.

La détection synchrone est typiquement mise en œuvre par un Amplificateur à Détection Synchrone ADS, ou« Lock In Amplifier » (LIA) en terminologie anglo-saxonne. Le signal est amplifié et multiplié par un signal référence (généré par un oscillateur interne ou externe). Un filtre passe bas de fréquence de coupure adaptée réalise l'intégration. La détection synchrone peut être réalisée de manière analogique ou numérique. Elle peut être améliorée en intégrant deux voies en quadrature.

Le nombre de modules de démodulation LIA 11 et le choix des différentes fréquences de modulation et de démodulation dépendent du type de capteurs de l'ensemble ER et de l'architecture de démodulation choisie.

Selon une première option illustrée figure 5 la démodulation s'opère en un seul étage. L'ensemble résonant SM0 comprend M éléments résonants Eij (Mi par résonateur Ri). Selon un exemple illustré figure 5 le dispositif de démodulation DDM comprend M modules de démodulation LIA configurés pour opérer respectivement M démodulation aux fréquences fmod(i) +/- fc(i,j). L'avantage est que cette architecture ne comprend qu'un seul étage, l'information étant obtenue par un seul traitement. La contrainte du choix des fréquences de modulation est qu'elle doit être préférentiellement supérieure à 10 fois la bande passante du capteur. Dans l'exemple de la figure 5 N=3 et Mi=3 pour tous les résonateurs Ri, soit M=9. Le dispositif de démodulation comprend dans ce cas 9 démodulateurs LIA 11(i,j).

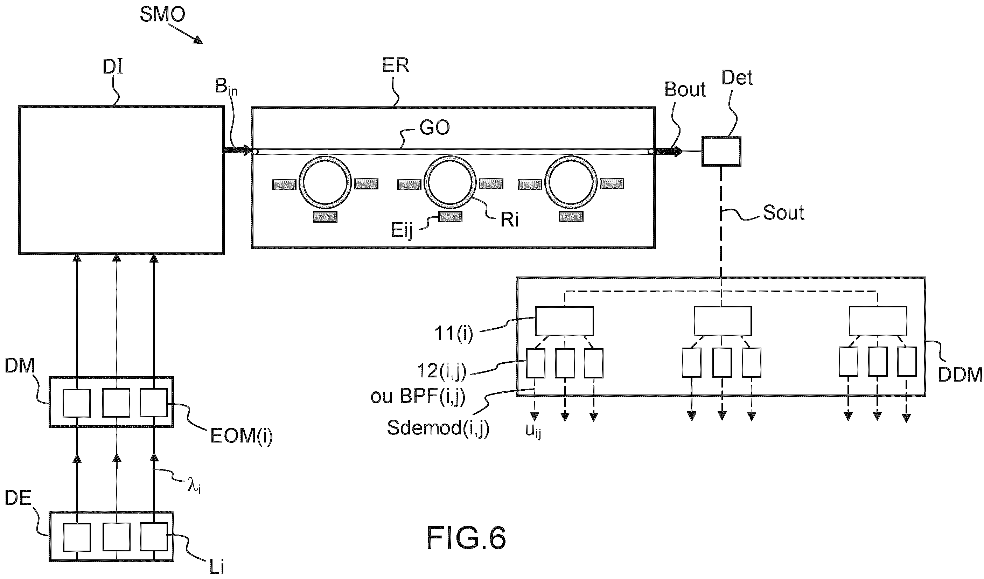

Selon une deuxième option illustrée figure 6 la démodulation s'opère en deux étages. Selon un exemple le dispositif de démodulation DDM comprend un premier étage comprenant N modules de démodulation LIA 11(i) configurés pour opérer respectivement N démodulations aux fréquences fmod(i) et comprend, pour chaque canal i un deuxième étage. Le deuxième étage comprend soit des modules de démodulation LIA 12(i,j) aux fréquences caractéristiques fc(i,j) soit des filtres spectraux BPF(i,j) configurés pour opérer un filtrage spectrale autour de la fréquence caractéristique fc(i,j).

Le choix entre les deux options dépend du signal à extraire.

Le document EP4109049 décrit également un système de mesure SM0 illustré figure 7 dans lequel l'ensemble résonant ENR comprend 3 disques constituant à la fois le résonateur optique et le résonateur mécanique. Les trois disques sont excités respectivement aux fréquences fex(1), fex(2) et fex(3), générées respectivement par 3 oscillateurs Oscex1, Oscex2, Oscex3. Les trois fréquences d'excitation sont respectivement comprises dans les bandes spectrales mécaniques BPm1, BP2m, BP3m autour des fréquences de résonance mécaniques frm1, frm2, frm3 des disques. Les signaux V1(t), V2(t) et V3(t) issus des oscillateurs sont transportés sur un même bus et injectés aux trois disques, chaque disque opérant un filtre et ne réagissant qu'à sa résonance propre. Ici il n'y a pas d'éléments Eij associés à chaque résonateur, c'est le résonateurs Ri lui-même qui fait office d'élément mécanique résonant, le disque étant dénommé dans ce cas Ri/Ei (double fonction).

Les fréquences de modulation fmod(1), fmod(2) et fmod(3) sont générées respectivement par trois oscillateurs sources Oscs1, Oscs2, Oscs3. La fréquence de démodulation fdemod(i) = fmod(i)+/-fex(i) est synthétisée à partir des deux signaux issus des deux oscillateurs Oscsi et Oscexi. Les fréquences de modulation sont typiquement choisies entre quelques KHz et quelques GHz.

Un inconvénient du système de mesure SM0 est l'utilisation de modulateurs externes pour la modulation des faisceaux lumineux injectés dans l'ensemble résonant, ce qui rend la fabrication de complexe et ne permet pas la réalisation d'un système tout intégré sur une puce. De plus, les modulateurs sont souvent sensibles à la polarisation de la lumière, ils nécessitent donc des éléments supplémentaires pour être utilisés (contrôleurs de polarisation), ce qui augmente la complexité du système. En outre les modulateurs peuvent présenter des pertes d'insertion importantes, qui doivent être compensées par le laser, ce qui induit une consommation de puissance supplémentaire.

Un but de la présente invention est de remédier aux inconvénients précités en proposant un système de mesure amélioré qui ne comprend pas de modulateurs externes et qui présente un ensemble résonant original.

### DESCRIPTION DE L'INVENTION

La présente invention a pour premier objet un système de mesure de type MEMs et/ou NEMs comprenant :
- un ensemble résonnant comprenant :
   o une entrée et une sortie,
   o une pluralité de N résonateurs OMRi indicés i, chaque résonateur étant configuré pour présenter à la fois une résonance optique à une longueur d'onde de résonance optique et une résonance mécanique à une fréquence de résonance mécanique frm/o(i) associée, lesdites longueur d'onde de résonance optique et lesdites fréquences de résonances mécaniques étant toutes différentes,
   o au moins un élément mécanique résonant MEij couplé à chaque résonateur OMRi, j étant l'indice de l'élément mécanique résonant associé au résonateur OMRi, ledit élément mécanique résonant présentant une fréquence de résonance mécanique, ladite fréquence de résonance mécanique étant le cas échéant différente des fréquences de résonance mécaniques des autres éléments mécaniques résonants couplés à un même résonateur,
   o au moins un guide d'onde auquel sont couplés les résonateurs optiques,
- un dispositif d'émission configuré pour émettre une pluralité de N faisceaux lumineux présentant chacun une longueur d'onde d'émission λi comprise dans une bande de résonance optique du résonateur optique associé,
- un dispositif d'injection configuré pour superposer les N faisceaux lumineux pour former un faisceau d'entrée (Bin) et pour injecter le faisceau d'entrée en entrée de l'ensemble résonant,
chaque résonateur OMRi de l'ensemble résonant étant en outre configuré pour être excité à une fréquence d'excitation mécanique dénommée première fréquence d'excitation, comprise dans une première bande de résonance mécanique dudit résonateur, et pour moduler le faisceau lumineux associé à ladite première fréquence d'excitation,
un élément mécanique résonant étant configuré pour être excité à une fréquence d'excitation mécanique, dénommée deuxième fréquence d'excitation, et pour modifier une transmission ou une réflexion optique au voisinage de la résonance optique dudit résonateur associé, ladite modification étant fonction d'une grandeur physique (u) à mesurer,
- au moins un détecteur configuré pour détecter un faisceau lumineux issu du faisceau en sortie de l'ensemble résonnant (Bout) et générer un signal de sortie,
- un dispositif de démodulation comprenant une pluralité de modules de démodulation de type détection synchrone, dénommé LIA, pour démoduler le signal de sortie, de manière à extraire des signaux caractéristiques associés à chaque élément mécanique résonant, des valeurs mesurées de ladite grandeur physique étant déterminées à partir desdits signaux caractéristiques.

Selon un mode de réalisation les résonateurs sont configurés de sorte que des longueurs des trajets de la lumière dans lesdits résonateurs sont différentes d'un résonateur à l'autre, une longueur de trajet étant liée à la longueur d'onde de résonance optique associée par la formule suivante :
${λ}_{ri} = \frac{PLi ⋅ {n}_{effi}}{m \left(i\right)}$ Avec PLi longueur du trajet optique de la lumière dans le résonateur OMRi, n_{effi} indice de réfraction effectif du matériau du résonateur OMRi, m(i) entier supérieur ou égal à 1 choisi pour chaque i.

Selon un mode de réalisation les résonateurs sont des disques de rayons Ri réalisé dans un même matériau, et qui vérifient la relation :
${λ}_{ri} = \frac{2 πRi ⋅ {n}_{eff}}{m \left(i\right)}$ avec n_{eff} indice de réfraction effectif du matériau des disques.

La présente invention a pour deuxième objet un système de mesure de type MEMs et/ou NEMs comprenant :
- un ensemble résonnant comprenant :
   o une entrée et une sortie,
   o une pluralité de N résonateurs OMRi indicés i, chaque résonateur étant configuré pour présenter à la fois une résonance optique à une longueur d'onde de résonance optique commune à tous les résonateurs et une résonance mécanique à une fréquence de résonance mécanique spécifique à chaque résonateur, lesdites fréquences de résonances mécaniques étant toutes différentes,
   o au moins un élément mécanique résonant MEij couplé à chaque résonateur OMRi, j étant l'indice de l'élément mécanique résonant associé au résonateur OMRi, ledit élément mécanique résonant présentant une fréquence de résonance mécanique, ladite fréquence de résonance mécanique étant le cas échéant différente des fréquences de résonance mécanique des autres éléments mécaniques résonants couplés à un même résonateur,
   o au moins un guide d'onde auquel sont couplés les résonateurs optiques,
   o un dispositif d'émission configuré pour émettre un faisceau lumineux dénommé faisceau d'entrée présentant une longueur d'onde optique λini comprise dans une bande de résonance optique identique pour tous les résonateurs optiques,
- un dispositif d'injection (DI) configuré pour injecter ledit faisceau d'entrée en entrée de l'ensemble résonant,
chaque résonateur OMRi de l'ensemble résonant étant en outre configuré pour être excité à une fréquence d'excitation mécanique, dénommée première fréquence d'excitation, comprise dans une première bande de résonance mécanique dudit résonateur, et pour moduler le faisceau lumineux à ladite première fréquence d'excitation,
un élément mécanique résonant étant configuré pour être excité à une fréquence d'excitation mécanique, dénommée deuxième fréquence d'excitation, et pour modifier une transmission ou une réflexion optique au voisinage de la résonance optique dudit résonateur, ladite modification étant fonction d'une grandeur physique à mesurer,
- au moins un détecteur configuré pour détecter un faisceau lumineux issu du faisceau en sortie de l'ensemble résonnant et générer un signal de sortie,
- un dispositif de démodulation (DDM) comprenant une pluralité de modules de démodulation de type détection synchrone, dénommé LIA, pour démoduler le signal de sortie, de manière à extraire des signaux caractéristiques associés à chaque élément mécanique résonant, des valeurs mesurées de ladite grandeur physique étant déterminées à partir desdits signaux caractéristiques.

Selon un mode de réalisation, les résonateurs sont réalisés dans un même matériau et configurés de sorte que les longueurs des trajets de la lumière dans lesdits résonateurs sont différentes d'un résonateur à l'autre, une longueur du trajet étant liée à la longueur d'onde de résonance optique par la formule suivante :
${λ}_{r} = \frac{PLi ⋅ {n}_{eff}}{m \left(i\right)}$ Avec PLi trajet optique de la lumière dans chacun des résonateurs OMRi, n_{eff} indice de réfraction effectif du matériau desdits résonateur OMRi, m(i) entier supérieur ou égal à 1 choisi pour chaque i.

Selon un mode de réalisation, les résonateurs sont des disques de rayons Ri réalisé dans un même matériau, et qui vérifient la relation :
${λ}_{r} = \frac{2 πRi ⋅ {n}_{eff}}{m \left(i\right)}$

Selon un autre mode de réalisation, les résonateurs sont réalisés dans un même matériau et présentent des dimensions identiques, les différentes fréquences de résonances mécaniques étant obtenues par modification, d'un résonateur à l'autre, des positions des éléments d'ancrage desdits disques.

Selon un mode de réalisation (commun aux deux objets), un résonateur est choisi parmi : un disque, un anneau, un hippodrome.

Selon un mode de réalisation (commun aux deux objets), un résonateur est excité via un actionnement choisi parmi un actionnement électrostatique, piézoélectrique, optique.

Selon un mode de réalisation (commun aux deux objets), un élément mécanique résonant est choisi parmi une poutre, un disque, une plateforme suspendue.

Selon un mode de réalisation (commun aux deux objets) un élément mécanique résonant est excité via un actionnement choisi parmi un actionnement électrostatique, piézoélectrique, thermique.

Selon un mode de réalisation (commun aux deux objets) une deuxième fréquence d'excitation d'un élément mécanique résonant couplé à un résonateur est identique à une deuxième fréquence d'excitation d'un élément mécanique résonnant couplé à un autre résonateur.

Selon un mode de réalisation (commun aux deux objets), les résonateurs sont excités auxdites premières fréquences d'excitation associées via des oscillateur dédiés, lesdits oscillateurs formant un premier ensemble d'oscillateurs , et lesdits éléments mécanique résonants sont excités auxdites deuxièmes fréquences d'excitation via des oscillateurs dédiés, lesdits oscillateurs formant un deuxième ensemble d'oscillateurs.

Selon un mode de réalisation (commun aux deux objets) des signaux issus des oscillateurs du premier ensemble transitent sur un premier bus commun pour l'excitation des résonateurs et/ou des signaux issus des oscillateurs du deuxième ensemble transitent sur un deuxième bus commun pour l'excitation des éléments mécanique résonants.

Selon un mode de réalisation (commun aux deux objets) les résonateurs sont actionnés via des premières électrodes reliées entre elles et reliées au premier bus.

Selon un mode de réalisation (commun aux deux objets) les éléments mécaniques résonant sont actionnés via des deuxièmes électrodes (EL1) reliées entre elles et reliées au deuxième bus (B2).

Selon un mode de réalisation (commun aux deux objets) lesdits oscillateurs du premier et du deuxième ensemble sont utilisés pour générer des fréquences de démodulation.

La présente invention concerne également un capteur de mesure comprenant une pluralité de M système de mesure selon le deuxième objet de l'invention, un système de mesure étant indicé k et formant un canal k, chaque canal présentant une longueur d'onde de résonance associée,
- lesdites entrées et les dites sorties étant confondues de sorte que les différents canaux opèrent en parallèle,
- le dispositif d'injection, le détecteur et le dispositif de démodulation étant commun à tous les canaux,
- chaque dispositif d'émission étant configuré pour émettre un faisceaux lumineux présentant une longueur d'onde d'émission λk comprise dans une bande de résonance du canal associé et le dispositif d'injection étant configuré pour superposer les M faisceaux lumineux pour former ledit faisceau d'entrée.

La description suivante présente plusieurs exemples de réalisation du dispositif de l'invention : ces exemples sont non limitatifs de la portée de l'invention. Ces exemples de réalisation présentent à la fois les caractéristiques essentielles de l'invention ainsi que des caractéristiques additionnelles liées aux modes de réalisation considérés.

L'invention sera mieux comprise et d'autres caractéristiques, buts et avantages de celle-ci apparaîtront au cours de la description détaillée qui va suivre et en regard des dessins annexés donnés à titre d'exemples non limitatifs et sur lesquels :
La figure 1 déjà citée décrit un résonateur optique en anneau selon l'état de l'art.
La figure 2 déjà citée décrit l'énergie E stockée dans le résonateur en fonction de la longueur d'onde.
La figure 3 déjà citée illustre un capteur optomécanique selon l'état de l'art comprenant un résonateur optique couplé avec un élément mécanique dont on mesure le déplacement, dans lequel l'élément mécanique est une poutre cantilever P fixée à une extrémité à un plot.
La figure 4 déjà citée décrit un système de mesure selon l'état de l'art comprenant plusieurs résonateurs optiques couplés à un guide d'onde et des éléments associés aux résonateurs optiques.
La figure 5 déjà citée illustre une première variante du système de mesure de la figure 4 dans laquelle la démodulation s'opère en un seul étage.
La figure 6 déjà citée illustre une deuxième variante du système de mesure de la figure 4 dans laquelle la démodulation s'opère en deux étages.
La figure 7 déjà citée décrit une variante du système de mesure de la figure 4 dans laquelle l'ensemble résonant comprend des disques constituant à la fois le résonateur optique et le résonateur mécanique.
La figure 8 illustre un résonateur couplé à un guide d'onde et comprenant un élément mécanique associé selon l'invention.
La figure 9 illustre, pour un résonateur qui vibre à la fréquence de résonance mécanique, la puissance lumineuse détectée à la sortie du guide d'onde en fonction de la longueur d'onde.
La figure 10 illustre trois exemples de résonateur optomécanique selon l'invention.
La figure 11 illustre une première variante du système de mesure selon l'invention, dans laquelle les résonateurs optomécaniques sont configurés pour présenter des longueurs d'onde de résonance optique qui sont toutes différentes.
La figure 12 illustre une deuxième variante du système de mesure selon l'invention, dans laquelle les résonateurs optomécaniques sont configurés pour présenter une longueur d'onde de résonance optique commune.
La figure 13 illustre un mode de réalisation compatible des deux variantes dans lequel le mode de démodulation est dit « à un étage ».
La figure 14 illustre un autre mode de réalisation compatible des deux variantes dans lequel le mode de démodulation est dit « à deux étages ».
La figure 15 illustre un mode de réalisation du système selon l'invention dans lequel on génère les premières fréquences d'excitation des résonateurs et les deuxièmes fréquences d'excitation des éléments mécanique résonants via des oscillateurs dédiés.
La figure 16 illustre un mode de réalisation du système selon l'invention dans lequel des signaux issus des oscillateurs du premier ensemble transitent sur un premier bus commun et/ou les signaux issus des oscillateurs du deuxième ensemble transitent sur un deuxième bus commun.
La figure 17 illustre un mode de réalisation du système selon l'invention dans lequel les résonateurs sont actionnés via des premières électrodes reliées entre elles et reliées au premier bus, et les éléments mécaniques résonants sont actionnés via des deuxièmes électrodes reliées entre elles et reliées au deuxième bus.
La figure 18 illustre un exemple d'un système selon la première variante de l'invention dans lequel l'ensemble résonnant est intégré sur une puce.
La figure 19 illustre un capteur de mesure selon un autre aspect de l'invention comprenant une pluralité de systèmes selon la deuxième variante du système selon l'invention.

### DESCRIPTION DETAILLEE DE L'INVENTION

L'invention concerne un système de mesure de type MEMs et/ou NEMs comprenant un ensemble résonant, le système selon l'invention reprenant certains aspects du système décrit dans le document EP4109049 mais présentant certaines différences et améliorations.

L'ensemble résonant ENR selon l'invention comprend une entrée E, une sortie S, et une pluralité de N résonateurs OMRi indicés i, chaque résonateur étant configuré pour présenter une résonance optique à une longueur d'onde de résonance optique (λr ou λri voir plus loin) et une résonance mécanique à une fréquence de résonance mécanique frm/o(i) associée. Les fréquences de résonances mécaniques frm/o(i) sont toutes différentes les unes des autres. Le résonateur OMR est un résonateur opto également dénommé optomécanique (existence d'une résonance optique et mécanique).

Chaque résonateur OMRi est couplé à au moins un élément mécanique résonant MEij, j étant l'indice de l'élément mécanique résonant associé au résonateur OMRi. L'élément mécanique résonant MEij présente une fréquence de résonance mécanique frm/e(i,j). Dans le cas où un résonateur est couplé à plusieurs éléments mécaniques résonants, les fréquences de résonance mécaniques des éléments mécaniques résonants couplés à un même résonateur sont toutes différentes entre elles.

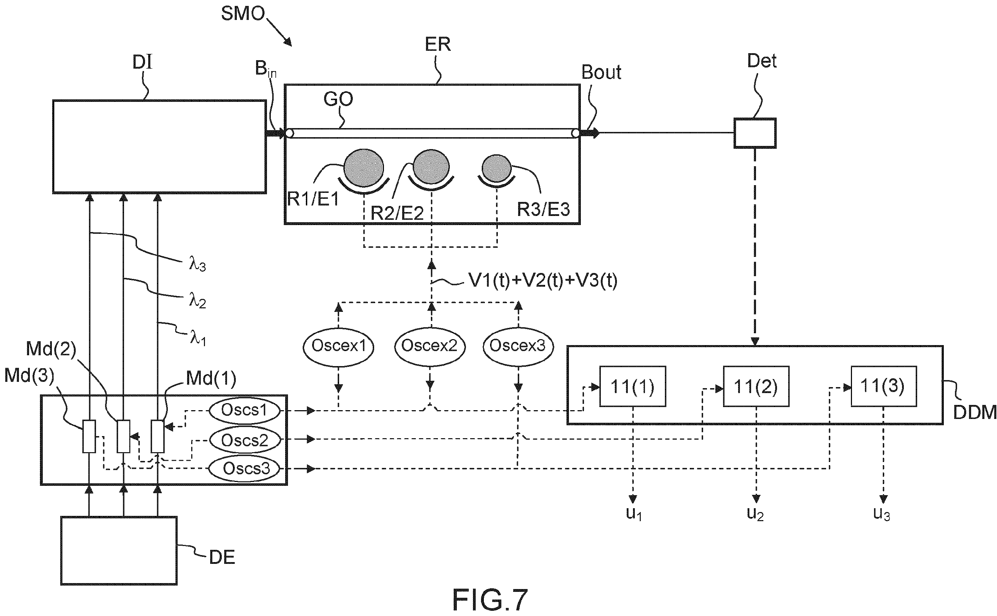

Il s'agit d'une différence avec la structure de l'ensemble résonant du document EP4109049 dans lequel les résonateurs optiques sont :
- soit couplés à des éléments mécaniques résonants et dans ce cas ils n'ont pas de résonance mécanique (figure 4 précitée de la présente demande),
- soit configurés pour présenter également une résonance mécanique, et dans ce cas ils ne sont couplés à aucun élément mécanique résonant (figure 7 précitée de la présente demande).

Les résonateurs optiques OMRi sont couplés à au moins un guide d'onde GO. C'est l'association (OMRi, MEij) qui forme un capteur élémentaire Cij.

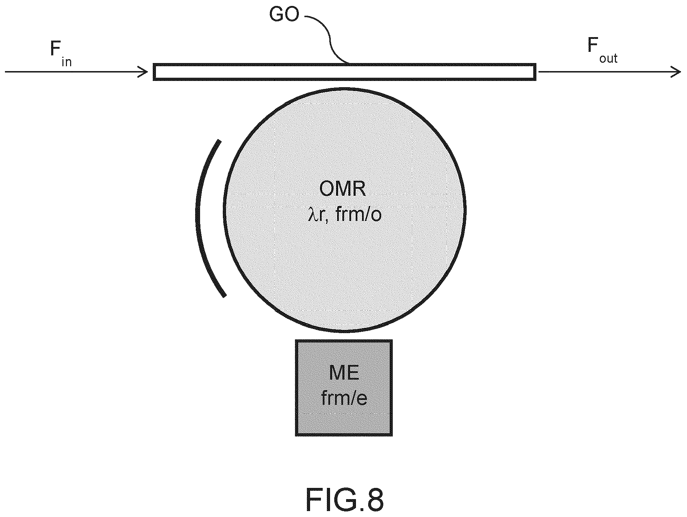

Un résonateur OMR couplé à un guide d'onde GO et comprenant un élément mécanique associé ME, est illustré figure 8. On dénomme Fin le faisceau laser entrant, de longueur d'onde λₗₐₛₑᵣ et Fout le faisceau laser sortant. Le résonateur OMR présente une longueur d'onde de résonance λr et une fréquence de résonance frm/o.

La longueur d'onde de résonance λr s'exprime par l'équation :
${λ}_{r} = \frac{PL ⋅ {n}_{eff}}{m} , m = 1 , 2 , 3 …$ (1)

Avec PL longueur du trajet optique parcouru par la lumière sur le périmètre du résonateur, neff l'indice effectif du matériau du résonateur, et m entier supérieur ou égal à 1 choisi. On a ainsi plusieurs longueurs d'onde de résonance optique accessibles.

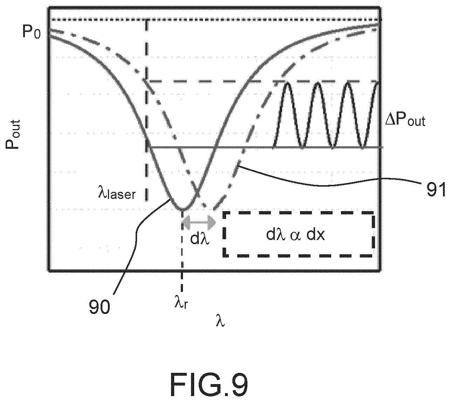

En tant que résonateur mécanique, le résonateur OMR peut vibrer à la fréquence de résonance frm/o. L'originalité de ce capteur élémentaire selon l'invention est que l'on utilise cette capacité à vibrer de résonateur optique OMR comme mécanisme de transduction pour moduler le faisceau lumineux qui le traverse, tel qu'illustré figure 9, qui décrit la puissance lumineuse Pout détectée à la sortie du guide d'onde en fonction de la longueur d'onde. La courbe 90 représente la résonance à λr. La longueur d'onde λₗₐₛₑᵣ est comprise dans la bande de résonance optique BPro du résonateur de largeur λr/Qopt, c'est-à-dire que λₗₐₛₑᵣ est localisée sur un côté du pic de résonance optique. Lorsque le résonateur OMR vibre mécaniquement en effectuant un déplacement Δx, il induit un changement périodique de la longueur PL du trajet optique parcouru par la lumière, ce qui induit une variation dλ de la longueur d'onde de résonance (équation (1)). La modulation de la longueur d'onde de résonance dλ induit une modulation ΔPout de l'onde lumineuse en sortie à la fréquence de vibration de Δx, soit la fréquence de résonance frm/o, tel qu'illustré figure 9.

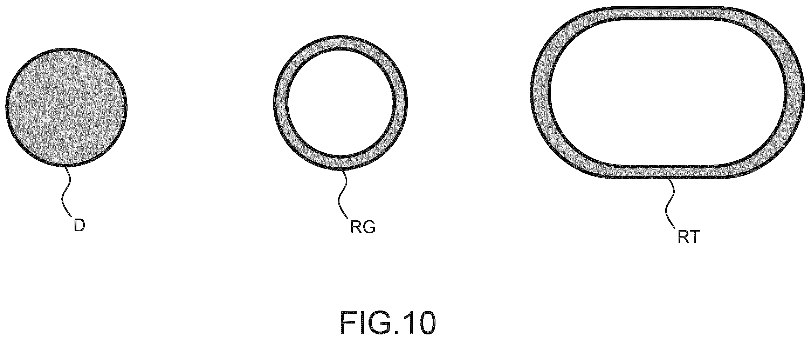

Préférentiellement, le résonateur optomécanique est choisi parmi un disque D, un anneau RG ou un hippodrome RT, tel qu'illustré figure 10.

Préférentiellement, les résonateurs sont excités via un actionnement choisi parmi un actionnement électrostatique, piézoélectrique, optique.

L'élément ME est un élément mécanique résonant à la fréquence frm/e. Le mouvement de l'élément mécanique résonant ME à proximité du résonateur optomécanique OMR (couplage de ME à OMR) entraine le changement de son indice de réfraction effectif neff (voir équation 1), donc un changement de la longueur d'onde de résonance, et module donc la puissance optique de sortie à la fréquence frm/e. C'est cette fréquence frm/e qui par sa perturbation, va permettre la mesure de u ou z (voir état de la technique).

En effet, chaque ME présente une fréquence de résonnance sensible à la mesurande. Typiquement on adapte, via une rétroaction, la fréquence d'excitation fex/e(i,j) à la fréquence de chaque élément, qui varie pendant la mesure, pour maintenir la résonance de l'élément mécanique malgré la perturbation. Ceci se fait, par exemple, à l'aide d'un oscillateur et d'une mesure de fréquence, ou bien d'une boucle d'asservissement de phase (« Phase-Locked Loop » en anglais).

Il s'agit ainsi, dans le système selon l'invention, d'une double modulation de la puissance de sortie via la modulation de la longueur d'onde de résonance :
- d'une part via la vibration mécanique du résonateur optomécanique OMR lui-même, qui modifie la longueur du trajet optique PL du résonateur optomécanique, et
- d'autre part via la vibration de l'élément mécanique résonant ME, qui modifie l'indice de réfraction effectif neff du résonateur optomécanique auquel il est couplé (déplacement à proximité du résonateur mais pas en contact).

La double modulation peut être effectuée sur la transmission de l'onde lumineuse comme illustré figure 10, ou sur sa réflexion.

L'élément mécanique résonant est préférentiellement choisi parmi une poutre (en porte-à faux), un disque, une plateforme suspendue.

Préférentiellement un élément mécanique résonant est excité via un actionnement choisi parmi un actionnement électrostatique, piezoélectrique, thermique.

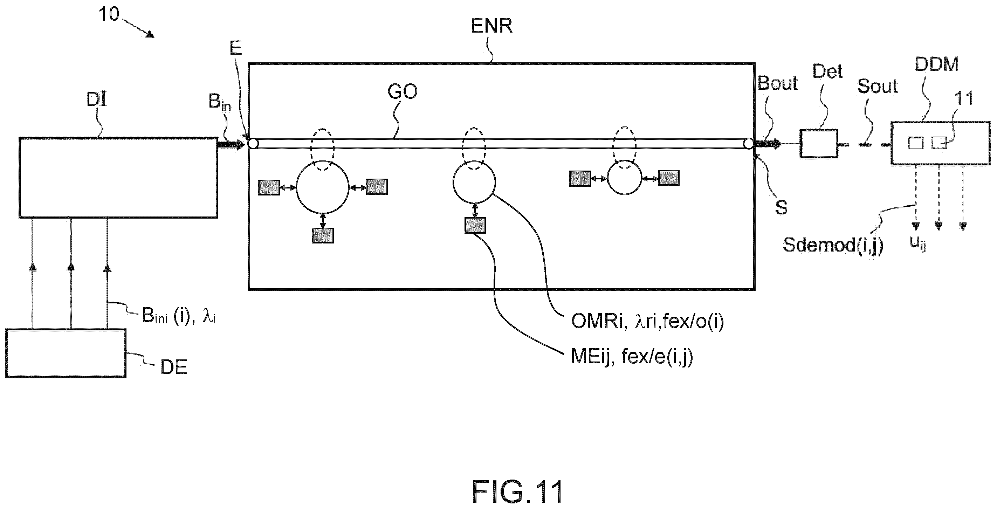

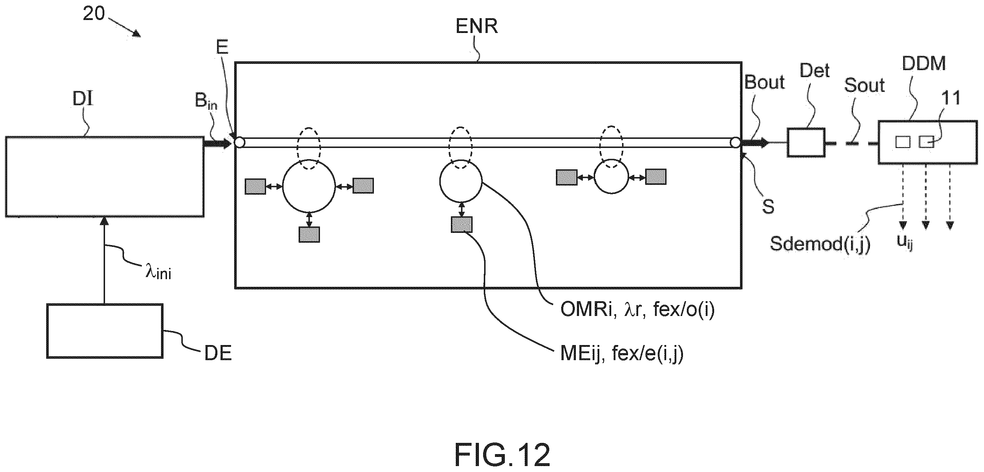

Cette double modulation associée au couple (OMRi, MEij) est appliquée dans un ensemble résonant ENR selon l'invention illustré figures 11 et 12 qui comprend, comme expliqué plus haut, la pluralité de résonateurs optomécaniques OMRi, un résonateur étant associé à au moins un élément mécanique résonant MEij. Un capteur élémentaire Cij constitué du couple (OMRi, ME(i,j)) permet la mesure de uij/zij.

Pour la mise en œuvre de l'ensemble résonant dans le système de mesure, il convient d'exciter le résonateur dans sa bande de résonance mécanique. Ainsi, chaque résonateur OMRi de l'ensemble résonant est configuré pour être excité à une fréquence d'excitation fex/o(i), dénommée première fréquence d'excitation, et pour moduler le faisceau lumineux associé à la première fréquence d'excitation fex/o(i). La première fréquence d'excitation fex/o(i) est comprise dans une première bande de résonance mécanique BPrm/o(i) du résonateur. La meilleure réponse est obtenue pour fex/o(i) = frm/o(i), mais un fonctionnement avec une excitation au voisinage de frm/o est également possible.

De même, il convient d'exciter un élément mécanique résonant dans sa bande sa bande de résonance mécanique. Un élément mécanique résonant MEij est configuré pour être excité à une fréquence d'excitation fex/e(i,j), dénommée deuxième fréquence d'excitation. La valeur de la fréquence de résonance frm/e est perturbée par la mesurande, et on adapte la deuxième fréquence d'excitation en conséquence pour maintenir en résonance l'élément ME.

La meilleure réponse est obtenue lorsque l'excitation est sur la fréquence de résonance de l'élément mécanique résonant, mais un fonctionnement avec une excitation au voisinage de la fréquence de résonance est également possible (deuxième bande passante de résonance).

L'élément mécanique résonant est configuré pour modifier une transmission ou une réflexion optique au voisinage de la résonance optique du résonateur associé, la modification étant fonction d'une grandeur physique u à mesurer.

A noter que l'on peut mesurer plusieurs grandeurs physiques, avec des éléments mécaniques sensibles à différentes grandeurs physiques.

Soumis à ces deux excitations le faisceau de sortie est ainsi modulé aux fréquences fex/o(i) +/- fex/e(i,j).

On dénomme Δi = 2.π.fex/o(i) et Ωij = 2.π.fex/e(i,j)

La pulsation Δi est issue de la modulation par le résonateur optomécanique OMRi, et la pulsation Ωij est issue de la modulation par l'élément mécanique résonant MEij.

Le système de mesure comprend également un dispositif d'émission DE pour l'onde lumineuse, un dispositif d'injection pour injecter cette onde lumineuse en entrée de l'ensemble résonant, au moins un détecteur Det configuré pour détecter le faisceau lumineux Bout issu du faisceau en sortie de l'ensemble résonnant et pour générer un signal de sortie Sout.

Selon le même principe que celui du document EP4109049, le système de mesure comprend enfin un dispositif de démodulation DDM comprenant une pluralité de modules de démodulation 11 de type détection synchrone, dénommé LIA, pour démoduler le signal de sortie de manière à extraire des signaux caractéristiques Sdemod(i,j) associés à chaque élément mécanique résonant. Les valeurs mesurées (uij, zij) de la grandeur physique (associée à l'élément mécanique résonant) sont déterminées à partir de ces signaux caractéristiques. Comme expliqué plus haut il est possible de mesurer plusieurs grandeurs physiques à partir d'éléments mécaniques sensibles à différentes grandeurs physiques.

Selon un exemple, on réalise la démodulation avec au moins N modules de démodulation. Selon un autre exemple, on réduit le nombre de modules de démodulation en réalisant un multiplexage temporel.

On voit que comparé au système de mesure du document EP4109049 le système de mesure selon l'invention ne comprend plus de modulateur externe pour moduler la lumière à la fréquence fmod(i), puisque ce sont les résonateurs optomécaniques OMRi eux-mêmes qui réalisent cette fonction. Cela permet de simplifier l'architecture du système et de le rendre plus intégrable.

Le système de mesure selon l'invention se décline selon deux variantes.

Le système de mesure 10 selon la première variante de l'invention, est illustré figure 11. Dans cette première variante les résonateurs optomécaniques OMRi sont configurés pour présenter des longueurs d'onde de résonance optique λri qui sont toutes différentes. Le dispositif d'émission DE est alors configuré pour émettre une pluralité de N faisceaux lumineux Bini(i) présentant chacun une longueur d'onde d'émission associée λi comprise dans la bande de résonance du résonateur optique associée BPro(i) (centrée sur λri). Selon un mode de réalisation le dispositif d'émission comprend N lasers configurés pour émettre les N faisceaux lumineux.

Le système de mesure 20 selon la deuxième variante de l'invention, est illustré figure 12. Dans cette deuxième variante les résonateurs optomécaniques OMRi sont configurés pour présenter une longueur d'onde de résonance optique commune λr. Le dispositif d'émission DE est alors configuré pour émettre un faisceau lumineux présentant la longueur d'onde d'émission λini comprise dans la bande de résonance du résonateur optique associée BPro (identique pour tous les résonateurs optomécaniques et centrée sur λr), et formant le faisceau d'entrée Bin.

Les fréquences de résonance mécaniques des résonateurs optomécaniques sont choisies de sorte que les bandes de résonance mécaniques ne se recoupent pas.

A noter, comme expliqué ci-dessus, que dans les deux variantes chaque résonateur optomécanique OMRi est configuré pour présenter une fréquence de résonance mécanique différente de celles des autres résonateurs optomécaniques OMRk≠i.

La première variante présente l'avantage de la simplicité de mise en œuvre, mais comprend plusieurs lasers, et le laser est un composant couteux et consommateur d'une puissance importante.

La deuxième variante est plus complexe à mettre en œuvre, mais présente l'avantage de ne nécessiter qu'un seul laser.

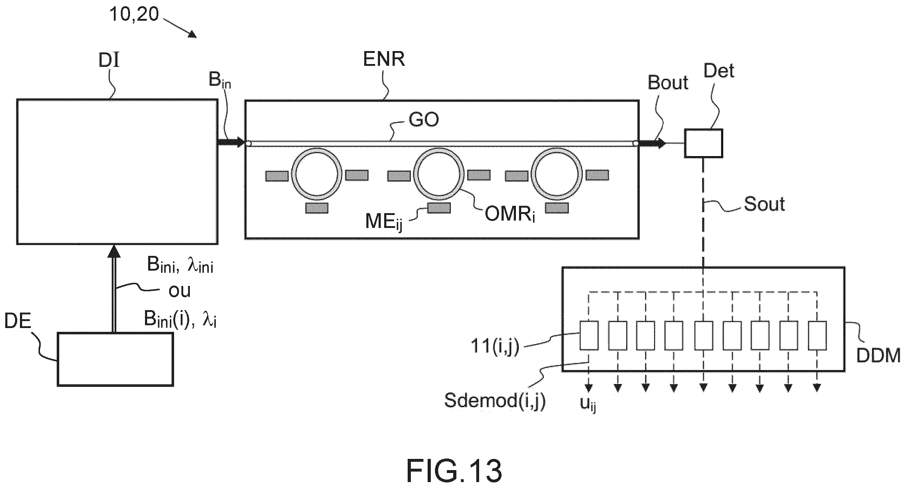

Selon un mode de réalisation compatible des deux variantes et illustré figure 13, l'ensemble résonant ENR comprend en tout P éléments mécaniques résonants, et le dispositif de démodulation DDM comprend P modules de démodulation LIA 11(i,j) configurés pour opérer respectivement P démodulation aux fréquences fex/o(i) +/- fex/e(i,j). Ce mode de démodulation dit « à un étage » est décrit dans le document EP4109049.

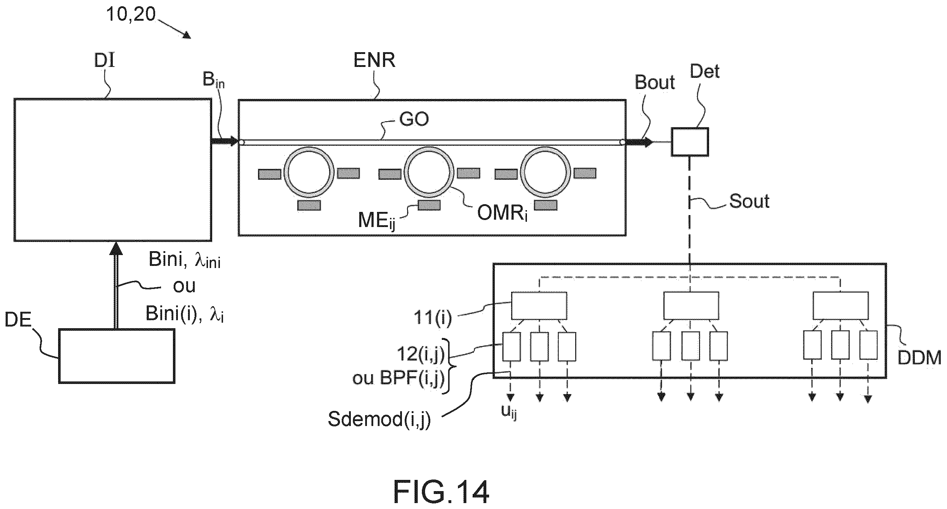

Selon un autre mode de réalisation compatible des deux variantes et illustré figure 14, le mode de démodulation est dit « à deux étages » (également décrit dans le document EP4109049). L'ensemble résonant ENR comprend un premier étage comprenant N modules de démodulation LIA 11(i) configurés pour opérer respectivement N démodulation aux fréquences fex/o(i).

Selon une première option, l'ensemble ENR comprend, pour chaque canal i, un deuxième étage comprenant des modules de démodulation 12(i,j) aux fréquences fex/e(i,j). Selon encore un autre mode de réalisation l'ensemble ENR comprend, pour chaque canal i, un deuxième étage comprenant des filtres spectraux BPF(i,j) configurés pour opérer un filtrage spectrale autour de la fréquence fex/e(i,j).

Selon un mode de réalisation également décrit dans le document EP4109049, un module de démodulation LIA comprend un oscillateur de référence à une fréquence de démodulation et une première chaine de démodulation comprenant un mélangeur et un filtre passe bas. Préférentiellement, un module de démodulation LIA comprend également une deuxième chaine de démodulation en quadrature avec la première chaine.

Pour la conception et la réalisation des résonateurs optomécaniques selon la première variante, selon un mode de réalisation les résonateurs OMRi sont configurés de sorte que des longueurs des trajets de la lumière dans les résonateurs PLi sont différentes d'un résonateur à l'autre, une longueur de trajet PLi étant liée à la longueur d'onde de résonance optique associée λri par la formule suivante, issue de l'équation 1 : ${λ}_{ri} = \frac{PLi . {n}_{effi}}{m \left(i\right)}$ (2) Avec :
PLi longueur du trajet optique de la lumière dans le résonateur OMRi n_{effi} indice de réfraction effectif du matériau du résonateur OMRi m(i) entier supérieur ou égal à 1 choisi pour chaque i.

Selon un mode de réalisation qui facilite la fabrication de l'ensemble résonant ENR, les résonateurs sont des disques de rayons Ri réalisés dans un même matériau, et qui vérifient la relation :
${λ}_{ri} = \frac{2 πRi ⋅ {n}_{eff}}{m \left(i\right)}$ Avec n_{eff} indice de réfraction effectif du matériau des disques.

En effet, dans le cas d'un disque ou d'une piste en forme de cercle de rayon *R* la longueur PL d'un tour de résonateur (c'est-à-dire du périmètre) est égale à 2.π.R.

Selon un exemple d'implémentation pratique pour un ensemble de deux résonateurs constitués de disques en silicium (indice effectif n=3.47), le rayon du premier résonateur optique est de *R*₁ = 5 *µ*m, et celui du deuxième résonateur *R*₂ = 5,05 *µm,* de façon à que *λ*₁ = 1557 *nm* et *λ*₂ = 1573 *nm* , avec m = 70 pour les deux cas.

Pratiquement, on adapte le paramètre Ri/m(i) pour obtenir une longueur de résonnance choisie.

Pour la conception et la réalisation des résonateurs optomécaniques selon la deuxième variante, selon un premier mode de réalisation les résonateurs OMRi sont configurés de sorte que les résonateurs OMRi sont réalisés dans un même matériau et configurés de sorte que les longueurs des trajets PLi de la lumière dans les résonateurs sont différentes d'un résonateur à l'autre, une longueur du trajet étant liée à la longueur d'onde de résonance optique λr par la formule suivante :
${λ}_{r} = \frac{PLi ⋅ {n}_{eff}}{m \left(i\right)}$ Avec :
PLi trajet optique de la lumière dans chacun des résonateurs OMRi n_{eff} indice de réfraction effectif du matériau desdits résonateur OMRi m(i) entier supérieur ou égal à 1 choisi pour chaque i.

Selon une option, les résonateurs sont des disques de rayons Ri réalisé dans un même matériau, et qui vérifient la relation :
${λ}_{r} = \frac{2 πRi ⋅ {n}_{eff}}{m \left(i\right)}$

Selon un exemple d'implémentation pratique, pour un ensemble de deux résonateurs constitués de disques en silicium et pour une longueur d'onde de résonance unique pour les deux résonateurs *λᵣ* = 1557.33 *nm,* on a : Résonateur 1 : *R*₁ = 5*µm*, *m*₁=70 Résonateur 2 : *R*₂ = 5.07*µm*, *m*₂=71

Ainsi, en changeant les deux paramètres R et m on parvient à fixer *λᵣ*. Dans ce cas, on sépare les capteurs grâce à la première fréquence d'excitation (fréquence de modulation optique), qui est fixée par le rayon *R*, et le système de mesure opère alors avec un seul laser.

Selon un deuxième mode de réalisation, les résonateurs sont réalisés dans un même matériau et présentent des dimensions identiques (par exemple disques de même rayon), les différentes fréquences de résonances mécaniques étant obtenues par modification, d'un résonateur à l'autre, des positions des éléments d'ancrage des résonateurs.

Pour ce mode de réalisation, un seul laser est nécessaire, car tous les résonateurs optiques ont la même longueur d'onde de résonnance. La sélection se fait par la fréquence de résonnance mécanique, qui elle varie d'un résonateur à l'autre. En conséquence, la complexité du système de lecture est moindre.

Selon un mode de réalisation, au moins une deuxième fréquence d'excitation d'un élément mécanique résonant couplé à un résonateur est identique à une deuxième fréquence d'excitation d'un élément mécanique résonnant couplé à un autre résonateur. En effet, ce qui est important est que les fréquences de résonance mécanique et donc d'excitation des éléments mécaniques couplés à un même résonateur optomécanique soient toutes différentes, pour que la démodulation s'effectue correctement.

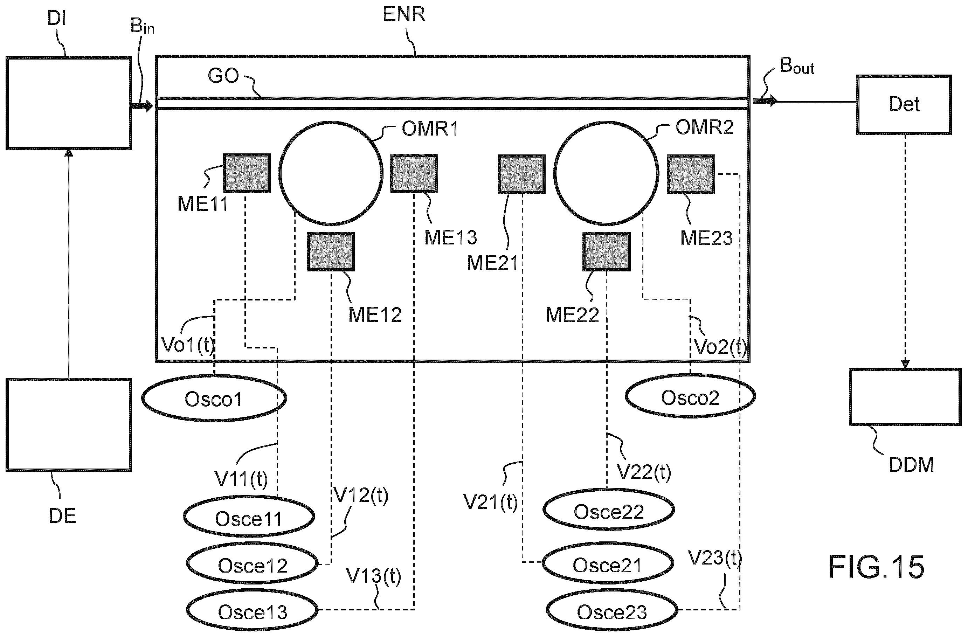

Pour l'implémentation du système (10 ou 20) selon l'invention, préférentiellement on génère les premières fréquences d'excitation fex/o(i) des résonateurs OMRi via des oscillateur dédiés Oscoi, tel qu'illustré sur la figure 15 pour un ensemble de deux résonateurs optomécaniques, chacun couplés à trois éléments mécaniques résonants. De même préférentiellement on génère les deuxièmes fréquences d'excitation fex/e(i,j) des éléments mécanique résonants MEij via des oscillateurs dédiés Osceij. On dénomme Voi(t) le signal généré par l'oscillateur Oscoi, et Vij(t) le signal généré par l'oscillateur Osceij.

Les oscillateurs Oscoi forment un premier ensemble d'oscillateurs EO1 et les oscillateurs Osceij forment un deuxième ensemble d'oscillateurs EO2.

Chaque résonateur OMRi ou élément mécanique résonant EMij ne résonne mécaniquement qu'avec une fréquence comprise dans sa bande de résonance mécanique, et il est donc possible de faire transiter tous les signaux d'excitation ou une partie d'entre eux via un bus commun. Un résonateur excité avec plusieurs signaux « reconnait » son signal d'excitation et ignore les autres.

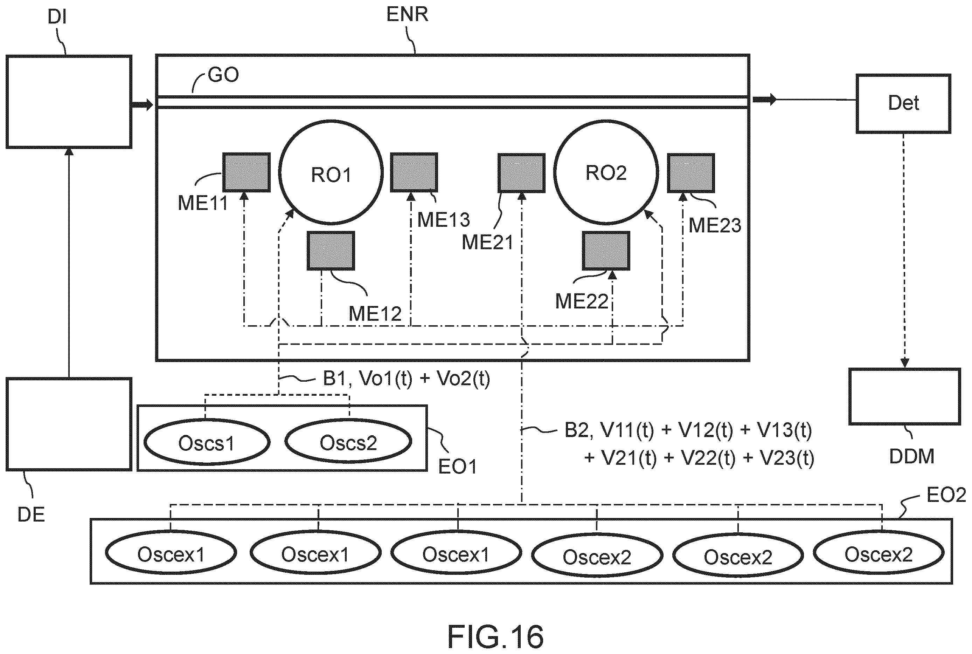

Ainsi selon un mode de réalisation illustré figure 16 des signaux issus des oscillateurs du premier ensemble transitent sur un premier bus commun B1 pour l'excitation des résonateurs et/ou les signaux issus des oscillateurs du deuxième ensemble transitent sur un deuxième bus commun B2 pour l'excitation des éléments mécaniques résonants. On peut mettre sur un bus commun aux signaux que l'on souhaite, en fonction des contraintes d'implémentation.

L'implémentation de bus communs permet de simplifier la fabrication et l'intégration de l'ensemble résonant et de son excitation.

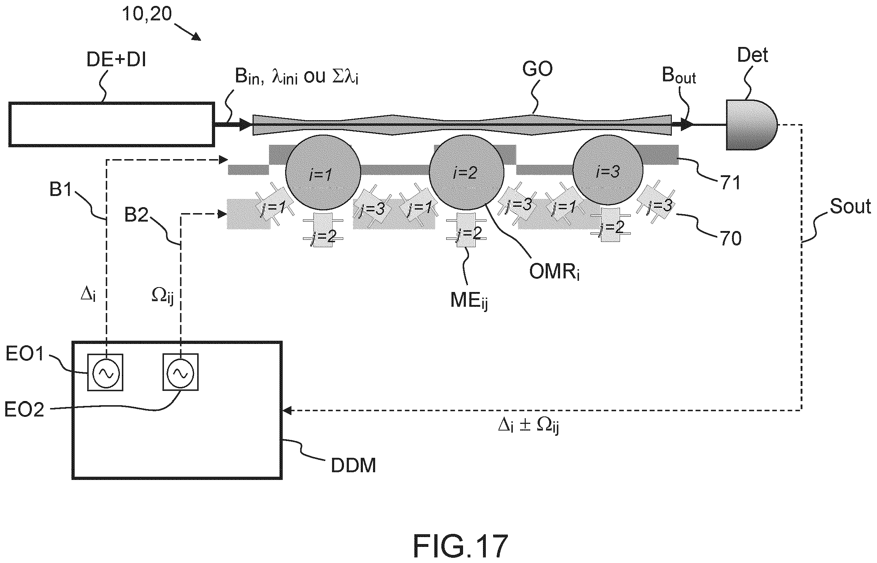

Selon un mode de réalisation les résonateurs OMRi sont actionnés via des premières électrodes EL1 reliées entre elles et reliées au premier bus B1, tel qu'illustré sur la figure 17 (i=3, j=3). Sur la figure 17 on a symbolisé les électrodes EL1 et leurs liaisons par la surface 71. De même selon un mode de réalisation les éléments mécaniques résonants MEij sont actionnés via des deuxièmes électrodes EL2 reliées entre elles et reliées au deuxième bus B2 (la surface 70 symbolise les électrodes EL2 et leurs liaisons).

Cette structure d'électrodes et de bus simplifie l'implémentation du système selon l'invention.

Préférentiellement, les oscillateurs du premier et du deuxième ensemble sont utilisés pour générer des fréquences de démodulation.

Préférentiellement, les oscillateurs sont intégrés au dispositif de démodulation DDM, tel qu'illustré figure 17.

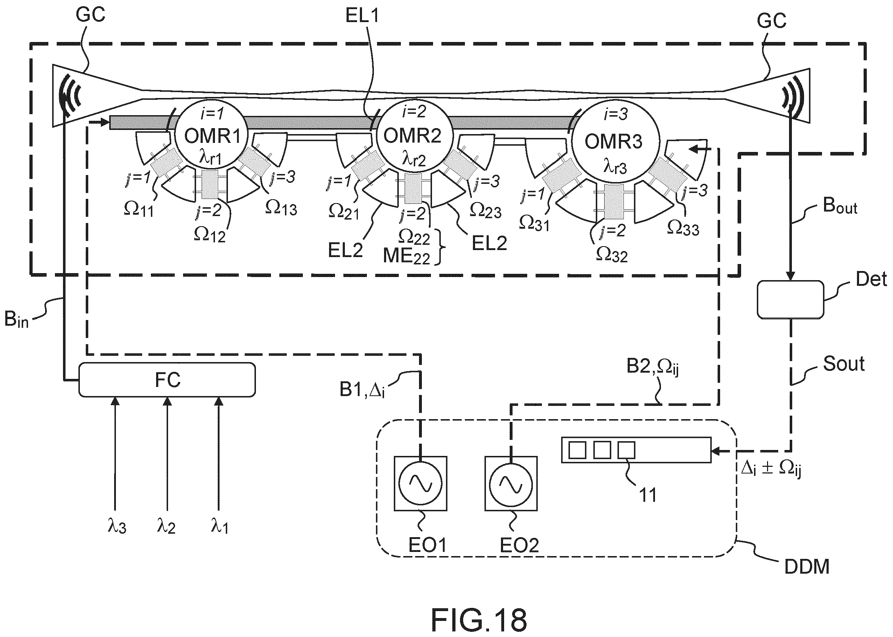

Selon un mode de réalisation, l'ensemble résonnant ENR est intégré sur une puce CHIP tel qu'illustré figure 18 pour un exemple selon la première variante. Dans cet exemple le dispositif d'injection DI comprend un coupleur à fibre FC qui superpose les N faisceaux lumineux pour former le faisceau Bin et un réseau de couplage GC qui injecte Bin dans le guide d'onde GO, et qui est également intégré sur la puce CHIP.

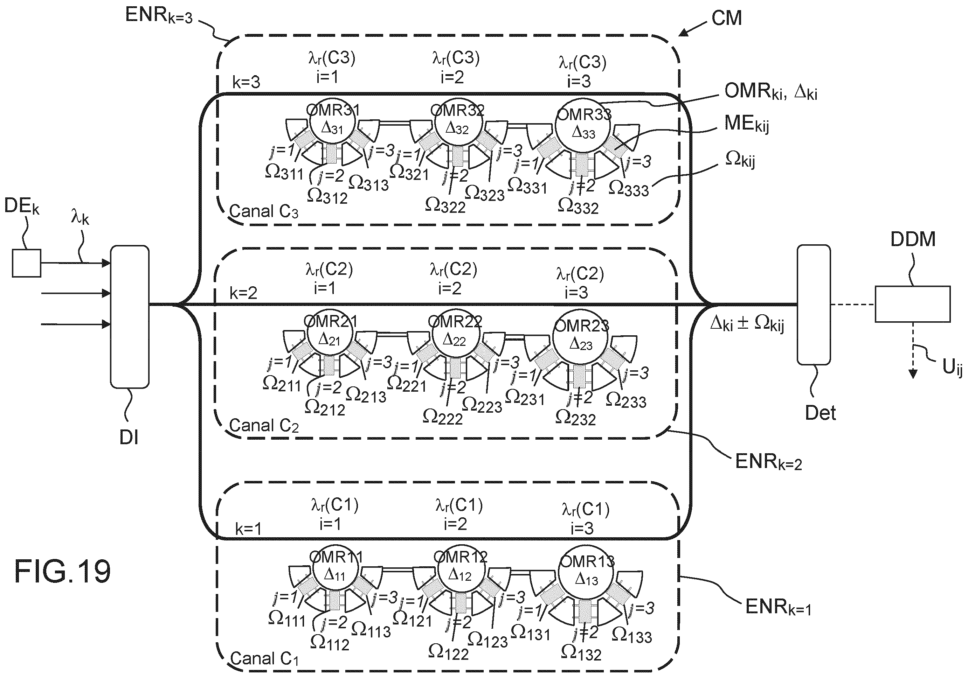

L'invention concerne également un capteur de mesure CM illustré figure 19 comprenant M systèmes selon la deuxième variante. Le système est indicé k et est dénommé canal. La figure 19 illustre le cas M=3, chaque ensemble résonant comprenant N=3 résonateurs optomécaniques couplés chacun à 3 éléments mécaniques résonants. Les ensembles résonants ENRk fonctionnement en parallèle : les entrées Ek et les sorties Sk des M systèmes sont confondues de sorte que les différents canaux opèrent en parallèle. Le dispositif d'injection DI, le détecteur Det et le dispositif de démodulation DDM est commun à tous les canaux.

On dénomme Δki la pulsation de la fréquence mécanique d'excitation du résonateur n°i du système k et Ωkij la pulsation de la fréquence mécanique d'excitation de l'élément résonant n°j couplé au résonateur n°i du système k.

Chaque canal k présente une longueur d'onde de résonance associée λr(Ck).

Chaque dispositif d'émission DEk est configuré pour émettre un faisceau lumineux présentant une longueur d'onde d'émission λk comprise dans une bande de résonance du canal associé et le dispositif d'injection DI est configuré pour superposer les M faisceaux lumineux, pour former le faisceau d'entrée Bin.

On a ainsi réalisé un multiplexage en longueur d'onde, qui permet de multiplier le nombre de capteurs élémentaires Ckij (OMRki, MEkij) sans rajouter de la complexité au système, et en gardant une seule entrée et une seule sortie.

## Revendications

1. Système de mesure (10) de type MEMs ou NEMs comprenant :
- un ensemble résonnant (ENR) comprenant :
o une entrée (E) et une sortie (S),
o une pluralité de N résonateurs OMRi indicés i, chaque résonateur étant configuré pour présenter à la fois une résonance optique à une longueur d'onde de résonance optique (λri) et une résonance mécanique à une fréquence de résonance mécanique (frm/o(i)) associée, lesdites longueur d'onde de résonance optique et lesdites fréquences de résonances mécaniques étant toutes différentes,
o au moins un élément mécanique résonant MEij couplé à chaque résonateur OMRi, j étant l'indice de l'élément mécanique résonant associé au résonateur OMRi, ledit élément mécanique résonant présentant une fréquence de résonance mécanique (frm/e(i,j)), ladite fréquence de résonance mécanique étant le cas échéant différente des fréquences de résonance mécaniques des autres éléments mécaniques résonants couplés à un même résonateur,
o au moins un guide d'onde (GO) auquel sont couplés les résonateurs optiques,
- un dispositif d'émission (DE) configuré pour émettre une pluralité de N faisceaux lumineux présentant chacun une longueur d'onde d'émission λi comprise dans une bande de résonance optique (BPro(i)) du résonateur optique associé,
- un dispositif d'injection (DI) configuré pour superposer les N faisceaux lumineux pour former un faisceau d'entrée (Bin) et pour injecter le faisceau d'entrée en entrée de l'ensemble résonant,
chaque résonateur OMRi de l'ensemble résonant étant en outre configuré pour être excité à une fréquence d'excitation (fex/o(i)) mécanique dénommée première fréquence d'excitation, comprise dans une première bande de résonance mécanique (BPrm/o(i)) dudit résonateur, et pour moduler le faisceau lumineux associé à ladite première fréquence d'excitation (fex/o(i)),
un élément mécanique résonant (MEij) étant configuré pour être excité à une fréquence d'excitation (fex/e(i,j)) mécanique, dénommée deuxième fréquence d'excitation, et pour modifier une transmission ou une réflexion optique au voisinage de la résonance optique dudit résonateur associé, ladite modification étant fonction d'une grandeur physique (u) à mesurer,
- au moins un détecteur (Det) configuré pour détecter un faisceau lumineux issu du faisceau en sortie de l'ensemble résonnant (Bout) et générer un signal de sortie (Sout),
- un dispositif de démodulation (DDM) comprenant une pluralité de modules de démodulation (11) de type détection synchrone, dénommé LIA, pour démoduler le signal de sortie, de manière à extraire des signaux caractéristiques (Sdemod(i,j)) associés à chaque élément mécanique résonant, des valeurs mesurées (uij, zij) de ladite grandeur physique étant déterminées à partir desdits signaux caractéristiques.

2. Système de mesure selon la revendication précédente dans lequel les résonateurs sont configurés de sorte que des longueurs des trajets de la lumière dans lesdits résonateurs (PLi) sont différentes d'un résonateur à l'autre, une longueur de trajet étant liée à la longueur d'onde de résonance optique associée par la formule suivante : ${λ}_{ri} = \frac{PLi ⋅ {n}_{effi}}{m \left(i\right)}$
Avec PLi longueur du trajet optique de la lumière dans le résonateur OMRi,
n_{effi} indice de réfraction effectif du matériau du résonateur OMRi,
m(i) entier supérieur ou égal à 1 choisi pour chaque i.

3. Système de mesure selon la revendication précédente dans lequel les résonateurs sont des disques de rayons Ri réalisé dans un même matériau, et qui vérifient la relation : ${λ}_{ri} = \frac{2 πRi ⋅ {n}_{eff}}{m \left(i\right)}$ avec n_{eff} indice de réfraction effectif du matériau des disques.

4. Système de mesure (20) de type MEMs ou NEMs comprenant :
- un ensemble résonnant (ENR) comprenant :
o une entrée (E) et une sortie (S),
o une pluralité de N résonateurs OMRi indicés i, chaque résonateur étant configuré pour présenter à la fois une résonance optique à une longueur d'onde de résonance optique (λr) commune à tous les résonateurs et une résonance mécanique à une fréquence de résonance mécanique (frm/o(i)) spécifique à chaque résonateur, lesdites fréquences de résonances mécaniques étant toutes différentes,
o au moins un élément mécanique résonant MEij couplé à chaque résonateur OMRi, j étant l'indice de l'élément mécanique résonant associé au résonateur OMRi, ledit élément mécanique résonant présentant une fréquence de résonance mécanique (frm/e(i,j)), ladite fréquence de résonance mécanique étant le cas échéant différente des fréquences de résonance mécanique des autres éléments mécaniques résonants couplés à un même résonateur,
o au moins un guide d'onde (GO) auquel sont couplés les résonateurs optiques,
- un dispositif d'émission (DE) configuré pour émettre un faisceau lumineux dénommé faisceau d'entrée (Bin) présentant une longueur d'onde optique λini comprise dans une bande de résonance optique (BPro) identique pour tous les résonateurs optiques,
- un dispositif d'injection (DI) configuré pour injecter ledit faisceau d'entrée (Bin) en entrée de l'ensemble résonant,
chaque résonateur OMRi de l'ensemble résonant étant en outre configuré pour être excité à une fréquence d'excitation (fex/o(i,j)) mécanique, dénommée première fréquence d'excitation, comprise dans une première bande de résonance mécanique (BPrm/o(i)) dudit résonateur, et pour moduler le faisceau lumineux à ladite première fréquence d'excitation (fex/o(i,j)),
un élément mécanique résonant étant configuré pour être excité à une fréquence d'excitation (fex/e(i,j)) mécanique, dénommée deuxième fréquence d'excitation, et pour modifier une transmission ou une réflexion optique au voisinage de la résonance optique dudit résonateur, ladite modification étant fonction d'une grandeur physique (u) à mesurer,
- au moins un détecteur (Det) configuré pour détecter un faisceau lumineux issu du faisceau en sortie de l'ensemble résonnant (Bout) et générer un signal de sortie (Sout),
- un dispositif de démodulation (DDM) comprenant une pluralité de modules de démodulation (11) de type détection synchrone, dénommé LIA, pour démoduler le signal de sortie, de manière à extraire des signaux caractéristiques (Sdemod(i,j)) associés à chaque élément mécanique résonant, des valeurs mesurées (uij, zij) de ladite grandeur physique étant déterminées à partir desdits signaux caractéristiques.

5. Système de mesure selon la revendication précédente dans lequel les résonateurs sont réalisés dans un même matériau et configurés de sorte que les longueurs des trajets (PLi) de la lumière dans lesdits résonateurs sont différentes d'un résonateur à l'autre, une longueur du trajet étant liée à la longueur d'onde de résonance optique par la formule suivante : ${λ}_{r} = \frac{PLi ⋅ {n}_{eff}}{m \left(i\right)}$
Avec PLi trajet optique de la lumière dans chacun des résonateurs OMRi,
n_{eff} indice de réfraction effectif du matériau desdits résonateur OMRi,
m(i) entier supérieur ou égal à 1 choisi pour chaque i.

6. Système de mesure selon la revendication précédente dans lequel les résonateurs sont des disques de rayons Ri réalisé dans un même matériau, et qui vérifient la relation : ${λ}_{r} = \frac{2 πRi ⋅ {n}_{eff}}{m \left(i\right)}$

7. Système de mesure selon la revendication 4 dans lequel les résonateurs sont réalisés dans un même matériau et présentent des dimensions identiques, les différentes fréquences de résonances mécaniques étant obtenues par modification, d'un résonateur à l'autre, des positions des éléments d'ancrage desdits disques.

8. Système selon l'une des revendications précédentes dans lequel un résonateur est choisi parmi : un disque, un anneau, un hippodrome.

9. Système selon l'une des revendications précédentes dans lequel un résonateur est excité via un actionnement choisi parmi un actionnement électrostatique, piézoélectrique, optique.

10. Système selon l'une des revendications précédentes dans lequel un élément mécanique résonant est choisi parmi une poutre, un disque, une plateforme suspendue.

11. Système selon l'une des revendications précédentes dans lequel un élément mécanique résonant est excité via un actionnement choisi parmi un actionnement électrostatique, piézoélectrique, thermique.

12. Système selon l'une des revendications précédentes dans lequel au moins une deuxième fréquence d'excitation d'un élément mécanique résonant couplé à un résonateur est identique à une deuxième fréquence d'excitation d'un élément mécanique résonnant couplé à un autre résonateur.

13. Système selon l'une des revendications précédentes dans lequel les résonateurs (OMRi) sont excités auxdites premières fréquences d'excitation (fex/o(i)) associées via des oscillateur dédiés (Oscoi), lesdits oscillateurs formant un premier ensemble d'oscillateurs (EO1), et dans lequel lesdits éléments mécanique résonants (MEij) sont excités auxdites deuxièmes fréquences d'excitation (fex/e(i,j)) via des oscillateurs dédiés (Osceij), lesdits oscillateurs formant un deuxième ensemble d'oscillateurs (EO2).

14. Système selon la revendication précédente dans lequel des signaux issus des oscillateurs du premier ensemble transitent sur un premier bus commun (B1) pour l'excitation des résonateurs et/ou des signaux issus des oscillateurs du deuxième ensemble transitent sur un deuxième bus commun (B2) pour l'excitation des éléments mécanique résonants.

15. Système selon la revendication précédente dans lequel les résonateurs sont actionnés via des premières électrodes (EL1) reliées entre elles et reliées au premier bus (B1).

16. Système selon les revendications 14 ou 15 dans lequel les éléments mécanique résonant sont actionnés via des deuxièmes électrodes (EL1) reliées entre elles et reliées au deuxième bus (B2).

17. Système de mesure selon l'une des revendications 13 à 16 dans lequel lesdits oscillateurs du premier et du deuxième ensemble sont utilisés pour générer des fréquences de démodulation.

18. Capteur de mesure (30) comprenant une pluralité de M systèmes de mesure (20) selon l'une des revendications 4 à 7, un système de mesure étant indicé k et formant un canal k, chaque canal présentant une longueur d'onde de résonance associée (λrC(k)),
lesdites entrées (Ek) et les dites sorties (Sk) étant confondues de sorte que les différents canaux opèrent en parallèle,
le dispositif d'injection (DI), le détecteur (Det) et le dispositif de démodulation (DDM) étant commun à tous les canaux,
chaque dispositif d'émission (DEk) étant configuré pour émettre un faisceaux lumineux présentant une longueur d'onde d'émission λk comprise dans une bande de résonance du canal associé et le dispositif d'injection (DI) étant configuré pour superposer les M faisceaux lumineux pour former ledit faisceau d'entrée (Bin).

## Patentansprüche

1. MEMS- oder NEMS-Messsystem (10) umfassend:
- eine Resonanzanordnung (ENR) umfassend:
- einen Eingang (E) und einen Ausgang (S),
- eine Vielzahl von N OMRi-Resonatoren, indiziert mit i, wobei jeder Resonator konfiguriert ist, um sowohl eine optische Resonanz bei einer optischen Resonanzwellenlänge (*λ*ri) als auch eine mechanische Resonanz bei einer zugehörigen mechanischen Resonanzfrequenz (frm/o(i)) aufzuweisen, wobei die optischen Resonanzwellenlängen und die mechanischen Resonanzfrequenzen alle unterschiedlich sind,
- mindestens ein mechanisches Resonanzelement MEij, das mit jedem OMRi-Resonator gekoppelt ist, wobei j der Index des dem OMRi-Resonator zugehörigen mechanischen Resonanzelements ist, das mechanische Resonanzelement eine mechanische Resonanzfrequenz (frm/e(i,j)) aufweist, wobei sich die mechanische Resonanzfrequenz gegebenenfalls von den mechanischen Resonanzfrequenzen der anderen mechanischen Resonanzelemente unterscheidet, die mit demselben Resonator gekoppelt sind,
- mindestens einen Wellenleiter (GO), mit dem die optischen Resonatoren gekoppelt sind,
- eine Emissionsvorrichtung (DE), die konfiguriert ist, um eine Vielzahl von N Lichtstrahlen auszusenden, die jeweils eine Emissionswellenlänge *λ*i aufweisen, die in einem optischen Resonanzband (BPro(i)) des zugehörigen optischen Resonators liegt,
- eine Einspeisevorrichtung (DI), die konfiguriert ist, um die N Lichtstrahlen zu überlagern, um einen Eingangsstrahl (Bin) zu bilden, und um den Eingangsstrahl in den Eingang der Resonanzanordnung einzuspeisen,
wobei jeder OMRi-Resonator der Resonanzanordnung zudem konfiguriert ist, um mit einer mechanischen Anregungsfrequenz (fex/o(i)), die als erste Anregungsfrequenz bezeichnet wird und in einem ersten mechanischen Resonanzband (BPrm/o(i)) des Resonators liegt, angeregt zu werden und um den der ersten Anregungsfrequenz (fex/o(i)) zugehörigen Lichtstrahl zu modulieren,
wobei ein mechanisches Resonanzelement (MEij) konfiguriert ist, um mit einer mechanischen Anregungsfrequenz (fex/e(i,j)), die als zweite Anregungsfrequenz bezeichnet wird, angeregt zu werden und um eine optische Transmission oder Reflexion im der Nähe der optischen Resonanz des zugehörigen Resonators zu verändern, wobei die Veränderung von einer zu messenden physikalischen Größe (u) abhängt,
- mindestens einen Detektor (Det), der konfiguriert ist, um einen Lichtstrahl zu erkennen, der aus dem Ausgangsstrahl der Resonanzanordnung (Bout) stammt, und ein Ausgangssignal (Sout) zu erzeugen,
- eine Demodulationsvorrichtung (DDM), die eine Vielzahl von Demodulationsmodulen (11) vom Typ der synchronen Detektion, als LIA bezeichnet, umfasst, um das Ausgangssignal zu demodulieren, um so charakteristische Signale (Sdemod(i,j)) zu extrahieren, die jedem mechanischen Resonanzelement zugehörig sind, wobei die Messwerte (uij, zij) der physikalischen Größe anhand der charakteristischen Signale bestimmt werden.

2. Messsystem nach dem vorstehenden Anspruch, wobei die Resonatoren so konfiguriert sind, dass sich Lichtweglängen in den Resonatoren (PLi) von Resonator zu Resonator unterscheiden, wobei eine Lichtweglänge mit der zugehörigen optischen Resonanzwellenlänge durch die folgende Formel in Beziehung steht: ${λ}_{ri} = \frac{PLi ⋅ {n}_{effi}}{m \left(i\right)}$ wobei PLi die optische Lichtweglänge in dem OMRi-Resonator ist, n_{effi} der effektive Brechungsindex des Materials des OMRi-Resonators ist, m(i) eine ganze Zahl größer als oder gleich 1 ist, die für jedes i gewählt wird.

3. Messsystem nach dem vorstehenden Anspruch, wobei die Resonatoren Scheiben mit dem Radius Ri sind, die aus demselben Material bestehen und die folgende Beziehung erfüllen: ${λ}_{ri} = \frac{2 πRi ⋅ {n}_{eff}}{m \left(i\right)}$ wobei n_{eff} der effektive Brechungsindex des Materials der Scheiben ist.

4. MEMS- oder NEMS-Messsystem (20) umfassend:
- eine Resonanzanordnung (ENR) umfassend:
- einen Eingang (E) und einen Ausgang (S),
- eine Vielzahl von N OMRi-Resonatoren, indiziert mit i, wobei jeder Resonator konfiguriert ist, um sowohl eine optische Resonanz bei einer optischen Resonanzwellenlänge (*λ*r), die allen Resonatoren gemeinsam ist, als auch eine mechanische Resonanz bei einer zugehörigen mechanischen Resonanzfrequenz (frm/o(i)), die für jeden Resonator spezifisch ist, aufzuweisen, wobei die optischen Resonanzwellenlängen und die mechanischen Resonanzfrequenzen alle unterschiedlich sind,
- mindestens ein mechanisches Resonanzelement MEij, das mit jedem OMRi-Resonator gekoppelt ist, wobei j der Index des dem OMRi-Resonator zugehörigen mechanischen Resonanzelements ist, das mechanische Resonanzelement eine mechanische Resonanzfrequenz (frm/e(i,j)) aufweist, wobei sich die mechanische Resonanzfrequenz gegebenenfalls von den mechanischen Resonanzfrequenzen der anderen mechanischen Resonanzelemente unterscheidet, die mit demselben Resonator gekoppelt sind,
- mindestens einen Wellenleiter (GO), mit dem die optischen Resonatoren gekoppelt sind,
- eine Emissionsvorrichtung (DE), die konfiguriert ist, um einen Lichtstrahl, der als Eingangslichtstrahl (Bin) bezeichnet wird, auszusenden, die eine optische Wellenlänge λini aufweist, die in einem optischen Resonanzband (BPro) liegt, das für alle optischen Resonatoren identisch ist,
- eine Einspeisevorrichtung (DI), die konfiguriert ist, um den Eingangsstrahl (Bin) in den Eingang der Resonanzanordnung einzuspeisen,
wobei jeder OMRi-Resonator der Resonanzanordnung zudem konfiguriert ist, um mit einer mechanischen Anregungsfrequenz (fex/o(i,j)), die als erste Anregungsfrequenz bezeichnet wird und in einem ersten mechanischen Resonanzband (BPrm/o(i)) des Resonators liegt, angeregt zu werden und um den der ersten Anregungsfrequenz (fex/o(i,j)) Lichtstrahl zu modulieren,
wobei ein mechanisches Resonanzelement konfiguriert ist, um mit einer mechanischen Anregungsfrequenz (fex/e(i,j)), die als zweite Anregungsfrequenz bezeichnet wird, angeregt zu werden und um eine optische Transmission oder Reflexion im der Nähe der optischen Resonanz des Resonators zu verändern, wobei die Veränderung von einer zu messenden physikalischen Größe (u) abhängt,
- mindestens einen Detektor (Det), der konfiguriert ist, um einen Lichtstrahl zu erkennen, der aus dem Ausgangsstrahl der Resonanzanordnung (Bout) stammt, und ein Ausgangssignal (Sout) zu erzeugen,
- eine Demodulationsvorrichtung (DDM), die eine Vielzahl von Demodulationsmodulen (11) vom Typ der synchronen Detektion, als LIA bezeichnet, umfasst, um das Ausgangssignal zu demodulieren, um so charakteristische Signale (Sdemod(i,j)) zu extrahieren, die jedem mechanischen Resonanzelement zugehörig sind, wobei die Messwerte (uij, zij) der physikalischen Größe anhand der charakteristischen Signale bestimmt werden.

5. Messsystem nach dem vorstehenden Anspruch, wobei die Resonatoren aus demselben Material bestehen und so konfiguriert sind, dass sich die Lichtweglängen (PLi) in den Resonatoren von Resonator zu Resonator unterscheiden, wobei eine Lichtweglänge mit der optischen Resonanzwellenlänge durch die folgende Formel in Beziehung steht: ${λ}_{r} = \frac{PLi ⋅ {n}_{eff}}{m \left(i\right)}$ wobei PLi der optische Lichtweg in jedem der OMRi-Resonatoren ist, n_{eff} der effektive Brechungsindex des Materials der OMRi-Resonatoren ist, m(i) eine ganze Zahl größer als oder gleich 1 ist, die für jedes i gewählt wird.

6. Messsystem nach dem vorstehenden Anspruch, wobei die Resonatoren Scheiben mit dem Radius Ri sind, die aus demselben Material bestehen und die folgende Beziehung erfüllen: ${λ}_{r} = \frac{2 πRi ⋅ {n}_{eff}}{m \left(i\right)}$

7. Messsystem nach Anspruch 4, wobei die Resonatoren aus demselben Material bestehen und identische Abmessungen aufweisen, wobei die unterschiedlichen mechanischen Resonanzfrequenzen dadurch erzielt werden, dass die Positionen der Verankerungselemente der Scheiben von Resonator zu Resonator variiert werden.

8. System nach einem der vorstehenden Ansprüche, wobei ein Resonator ausgewählt ist aus: einer Scheibe, einem Ring, einem Hippodrom.

9. System nach einem der vorstehenden Ansprüche, wobei ein Resonator über eine Ansteuerung angeregt wird, die aus einer elektrostatischen, piezoelektrischen oder optischen Ansteuerung ausgewählt ist.

10. System nach einem der vorstehenden Ansprüche, wobei ein mechanisches Resonanzelement aus einem Balken, einer Scheibe oder einer aufgehängten Plattform ausgewählt ist.

11. System nach einem der vorstehenden Ansprüche, wobei ein mechanisches Resonanzelement über eine Ansteuerung angeregt wird, die aus einer elektrostatischen, piezoelektrischen oder optischen Ansteuerung ausgewählt ist.

12. System nach einem der vorstehenden Ansprüche, wobei mindestens eine zweite Anregungsfrequenz eines mit einem Resonator gekoppelten mechanischen Resonanzelements mit einer zweiten Anregungsfrequenz eines mit einem anderen Resonator gekoppelten mechanischen Resonanzelements identisch ist.

13. System nach einem der vorstehenden Ansprüche, wobei die Resonatoren (OMRi) über dedizierte Oszillatoren (Oscoi) mit den zugehörigen ersten Anregungsfrequenzen (fex/o(i)) angeregt werden, wobei die Oszillatoren eine erste Oszillatoranordnung (EO1) bilden, und wobei die mechanischen Resonanzelemente (MEij) über dedizierte Oszillatoren (Osceij) mit den zweiten Anregungsfrequenzen (fex/e(i,j)) angeregt werden, wobei die Oszillatoren eine zweite Oszillatoranordnung (EO2) bilden.

14. System nach dem vorstehenden Anspruch, wobei Signale von den Oszillatoren der ersten Anordnung über einen ersten gemeinsamen Bus (B1) zur Anregung der Resonatoren übertragen werden und/oder Signale von den Oszillatoren der zweiten Anordnung über einen zweiten gemeinsamen Bus (B2) zur Anregung der mechanischen Resonanzelemente übertragen werden.

15. System nach dem vorstehenden Anspruch, wobei die Resonatoren über erste Elektroden (EL1) angesteuert werden, die miteinander verbunden sind und mit dem ersten Bus (B1) verbunden sind.

16. System nach einem der Ansprüche 14 oder 15, wobei die mechanischen Resonanzelement über zweite Elektroden (EL1) angesteuert werden, die miteinander verbunden sind und mit dem zweiten Bus (B2) verbunden sind.

17. Messsystem nach einem der Ansprüche 13 bis 16, wobei die Oszillatoren der ersten und der zweiten Anordnung zur Erzeugung von Demodulationsfrequenzen verwendet werden.

18. Messsensor (30) umfassend eine Vielzahl von M Messsystemen (20) nach einem der Ansprüche 4 bis 7, wobei ein Messsystem mit k indiziert ist und einen Kanal k bildet, wobei jeder Kanal eine zugehörige Resonanzwellenlänge (λrC(k)) aufweist,
wobei die Eingänge (Ek) und die Ausgänge (Sk) miteinander verbunden sind, sodass die verschiedenen Kanäle parallel arbeiten,
wobei die Einspeisevorrichtung (DI), der Detektor (Det) und die Demodulationsvorrichtung (DDM) für alle Kanäle gemeinsam sind,
wobei jede Emissionsvorrichtung (DEk) konfiguriert ist, um einen Lichtstrahl, der eine Emissionswellenlänge *λ*k aufweist, auszusenden, die in einem Resonanzband des zugehörigen Kanals liegt, und die Einspeisevorrichtung (DI) konfiguriert ist, um die M Lichtstrahlen zu überlagern, um den Eingangsstrahl (Bin) zu bilden.

## Claims

1. A MEMS- or NEMS-type measurement system (10) comprising:
- a resonant assembly (ENR) comprising:
- an input (E) and an output (S),
- a plurality of N OMRi resonators indexed i, each resonator being configured to exhibit both an optical resonance at an optical resonance wavelength (*λ*ri) and a mechanical resonance at an associated mechanical resonance frequency (frm/o(i)), said optical resonance wavelengths and said mechanical resonance frequencies all being different,
- at least one mechanical resonant element MEij coupled to each OMRi resonator, where j is the index of the mechanical resonant element associated with the OMRi resonator, said mechanical resonant element having a mechanical resonance frequency (frm/e(i,j)), said mechanical resonance frequency being, if necessary, different from the mechanical resonance frequencies of the other mechanical resonant elements coupled to the same resonator,
- at least one waveguide (GO) to which the optical resonators are coupled,
- a transmission device (DE) configured to transmit a plurality of N light beams, each having a transmission wavelength *λ*i within an optical resonance band (BPro(i)) of the associated optical resonator,
- an injection device (DI) configured to superimpose the N light beams to form an input beam (Bin) and to inject the input beam into the input of the resonant assembly,
each OMRi resonator of the resonant assembly being further configured to be excited at a mechanical excitation frequency (fex/o(i)) referred to as the first excitation frequency, which lies within a first mechanical resonance band (BPrm/o(i)) of said resonator, and to modulate the associated light beam at said first excitation frequency (fex/o(i)),
a mechanical resonant element (MEij) configured to be excited at a mechanical excitation frequency (fex/e(i,j)), referred to as the second excitation frequency, and to modify optical transmission or reflection in the vicinity of the optical resonance of said associated resonator, said modification being a function of a physical quantity (u) to be measured,
- at least one detector (Det) configured to detect a light beam originating from the output beam of the resonant assembly (Bout) and to generate an output signal (Sout),
- a demodulation device (DDM) comprising a plurality of synchronous detection-type demodulation modules (11), referred to as LIA, for demodulating the output signal so as to extract characteristic signals (Sdemod(i,j)) associated with each mechanical resonant element, wherein measured values (uij, zij) of said physical quantity are determined from said characteristic signals.

2. The measurement system according to the preceding claim, wherein the resonators are configured such that the optical path lengths in said resonators (PLi) differ from one resonator to another, a path length being related to the associated optical resonance wavelength by the following formula: ${λ}_{ri} = \frac{PLi ⋅ {n}_{effi}}{m \left(i\right)}$ where PLi is the optical path length of light in the OMRi resonator, n_{effi} is the effective refractive index of the material of the OMRi resonator, and m(i) is an integer greater than or equal to 1 chosen for each i.

3. The measurement system according to the preceding claim, wherein the resonators are disks of radius Ri made of the same material, and which satisfy the relationship: ${λ}_{ri} = \frac{2 πRi ⋅ {n}_{eff}}{m \left(i\right)}$ where n_{eff} is the effective refractive index of the material of the disks.

4. A MEMS- or NEMS-type measurement system (20) comprising:
- a resonant assembly (ENR) comprising:
- an input (E) and an output (S),
- a plurality of N resonators OMRi, indexed i, each resonator being configured to exhibit both an optical resonance at an optical resonance wavelength (*λ*r) common to all resonators and a mechanical resonance at a mechanical resonance frequency (frm/o(i)) specific to each resonator, said mechanical resonance frequencies all being different,
- at least one mechanical resonant element MEij coupled to each OMRi resonator, where j is the index of the mechanical resonant element associated with the OMRi resonator, said mechanical resonant element having a mechanical resonance frequency (frm/e(i,j)), said mechanical resonance frequency being, if necessary, different from the mechanical resonance frequencies of the other mechanical resonant elements coupled to the same resonator,
- at least one waveguide (GO) to which the optical resonators are coupled,
- a transmission device (DE) configured to transmit a light beam, referred to as the input beam (Bin), having an optical wavelength λini within an optical resonance band (BPro) that is identical for all optical resonators,
- an injection device (DI) configured to inject said input beam (Bin) into the input of the resonant assembly,
each OMRi resonator in the resonant assembly is further configured to be excited at a mechanical excitation frequency (fex/o(i,j)), referred to as the first excitation frequency, within a first mechanical resonance band (BPrm/o(i)) of said resonator, and to modulate the light beam at said first excitation frequency (fex/o(i,j)),
a mechanical resonant element configured to be excited at a mechanical excitation frequency (fex/e(i,j)), referred to as the second excitation frequency, and to modify optical transmission or reflection in the vicinity of the optical resonance of said resonator, said modification being a function of a physical quantity (u) to be measured,
- at least one detector (Det) configured to detect a light beam originating from the output beam of the resonant assembly (Bout) and to generate an output signal (Sout),
- a demodulation device (DDM) comprising a plurality of synchronous detection-type demodulation modules (11), referred to as LIA, for demodulating the output signal so as to extract characteristic signals (Sdemod(i,j)) associated with each mechanical resonant element, wherein measured values (uij, zij) of said physical quantity are determined from said characteristic signals.

5. The measurement system according to the preceding claim, wherein the resonators are made of the same material and configured such that the optical path lengths (PLi) in said resonators differ from one resonator to another, a path length being related to the optical resonance wavelength by the following formula: ${λ}_{r} = \frac{PLi ⋅ {n}_{eff}}{m \left(i\right)}$ where PLi is the optical path length of light in each of the OMRi resonators, n_{eff} is the effective refractive index of the material of said OMRi resonators, and m(i) is an integer greater than or equal to 1 chosen for each i.

6. The measurement system according to the preceding claim, wherein the resonators are disks of radius Ri made of the same material, and which satisfy the relationship: ${λ}_{r} = \frac{2 πRi ⋅ {n}_{eff}}{m \left(i\right)}$

7. The measurement system according to claim 4, wherein the resonators are made of the same material and have identical dimensions, the different mechanical resonance frequencies being obtained by modifying, from one resonator to another, the positions of the anchoring elements of said disks.

8. The system according to one of the preceding claims, wherein a resonator is selected from: a disk, a ring, or a horseshoe.

9. The system according to one of the preceding claims, wherein a resonator is excited via an actuation mechanism selected from an electrostatic, piezoelectric, or optical actuation mechanism.

10. The system according to one of the preceding claims, wherein a mechanical resonant element is selected from a beam, a disk, or a suspended platform.

11. The system according to one of the preceding claims, wherein a mechanical resonant element is excited via an actuation mechanism selected from an electrostatic, piezoelectric, or thermal actuation mechanism.

12. The system according to one of the preceding claims, wherein at least a second excitation frequency of a mechanical resonant element coupled to a resonator is identical to a second excitation frequency of a mechanical resonant element coupled to another resonator.

13. The system according to one of the preceding claims, wherein the resonators (OMRi) are excited at said associated first excitation frequencies (fex/o(i)) via dedicated oscillators (Oscoi), said oscillators forming a first arrangement of oscillators (EO1), and wherein said resonant mechanical elements (MEij) are excited at said second excitation frequencies (fex/e(i,j)) via dedicated oscillators (Osceij), said oscillators forming a second set of oscillators (EO2).

14. The system according to the preceding claim, wherein signals from the oscillators of the first set are transmitted over a first common bus (B1) for exciting the resonators, and/or signals from the oscillators of the second arrangement are transmitted over a second common bus (B2) for exciting the mechanical resonant elements.

15. The system according to the preceding claim, wherein the resonators are driven via first electrodes (EL1) that are interconnected and connected to the first bus (B1).

16. The system according to claim 14 or 15, wherein the mechanical resonant elements are driven via second electrodes (EL1) that are interconnected and connected to the second bus (B2).

17. The measurement system according to one of claims 13 through 16, wherein the oscillators of the first and second arrangements are used to generate demodulation frequencies.

18. A measurement sensor (30) comprising a plurality of M measurement systems (20) according to one of claims 4 through 7, wherein each measurement system is indexed k and forms a channel k, each channel having an associated resonance wavelength (λrC(k)),
said inputs (Ek) and said outputs (Sk) being combined such that the various channels operate in parallel,
the injection device (DI), the detector (Det), and the demodulation device (DDM) being common to all channels,
each transmission device (DEk) is configured to transmit a light beam having a transmission wavelength *λ*k within a resonance band of the associated channel, and the injection device (DI) is configured to superimpose the M light beams to form said input beam (Bin).
